(19) Europäisches Patentamt
European Patent Office
Office européen des brevets

(11) **EP 3 557 625 B1**

(12) **EUROPEAN PATENT SPECIFICATION**

(45) Date of publication and mention of the grant of the patent:
**07.08.2024 Bulletin 2024/32**

(21) Application number: **17879879.9**

(22) Date of filing: **12.12.2017**

(51) International Patent Classification (IPC):
*H01L 27/146* (2006.01)   *A61B 1/04* (2006.01)
*G02B 5/20* (2006.01)   *G02B 5/28* (2006.01)
*G02B 23/24* (2006.01)   *G02B 5/00* (2006.01)

(52) Cooperative Patent Classification (CPC):
**G02B 5/28; G02B 5/008; G02B 5/201;
H01L 27/14621; H01L 27/14685**

(86) International application number:
**PCT/JP2017/044628**

(87) International publication number:
**WO 2018/110572 (21.06.2018 Gazette 2018/25)**

(54) **IMAGING ELEMENT, AND ELECTRONIC DEVICE**

BILDGEBUNGSELEMENT UND ELEKTRONISCHE VORRICHTUNG

ÉLÉMENT D'IMAGERIE, ET DISPOSITIF ÉLECTRONIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.12.2016 JP 2016241255**

(43) Date of publication of application:
**23.10.2019 Bulletin 2019/43**

(73) Proprietor: **Sony Semiconductor Solutions
Corporation
Atsugi-shi, Kanagawa 243-0014 (JP)**

(72) Inventor: **SUGIZAKI Taro
Atsugi-shi
Kanagawa 243-0014 (JP)**

(74) Representative: **MFG Patentanwälte
Meyer-Wildhagen Meggle-Freund
Gerhard PartG mbB
Amalienstraße 62
80799 München (DE)**

(56) References cited:
WO-A1-2016/056396     JP-A- 2007 317 951
JP-A- 2009 027 684     JP-A- 2011 254 266
JP-A- 2014 064 196     US-A1- 2008 170 143
US-A1- 2010 238 330     US-A1- 2014 009 647
US-A1- 2014 084 404

**Description**

TECHNICAL FIELD

The present technology relates to an image pickup element and an electronic device and, more particularly, relates to an image pickup element and an electronic device that suppress a difference in sensitivity of light receiving units.

BACKGROUND ART

Conventionally, there has been proposed an image pickup element that detects light of a predetermined narrow wavelength band (narrow band) (hereinafter, also referred to as narrow band light) by using a plasmon filter (see, for example, Patent Document 1).
For example, Patent Document 2 discloses a color imaging element and an imaging apparatus. For example, Patent Document 3 discloses a solid-state imaging device equipped with a color filter. For example, Patent Document 4 discloses an imaging device.

CITATION LIST

PATENT DOCUMENT

Patent Document 1: International Publication No. 2016/059369
Patent Document 2: US 2014/009647 A1
Patent Document 3: US 2008/170143 A1
Patent Document 4: US 2014/084404 A1

SUMMARY OF THE INVENTION

PROBLEMS TO BE SOLVED BY THE INVENTION

Here, Patent Document 1 describes a pixel arrangement in which pixels in a same color are arranged in units of blocks of two rows and two columns. In a case where the pixels in a same color are aligned in a vertical direction or a horizontal direction in this manner, a difference in sensitivity is likely to occur between pixels in the same color, compared to a case where pixels in different colors area aligned. Patent Document 2 describes a color imaging element comprising an array of pixels, wherein each pixel comprises a color filter. The color imaging element is capable of reducing color moire and achieving high resolution.
The present technology has been made in view of such a situation and has an object to suppress the difference in sensitivity of the light receiving units such as pixels.

SOLUTIONS TO PROBLEMS

An image pickup element according to the present invention is disclosed in independent claim 1. Further solutions and aspects of the present invention are set forth in the dependent claims, the drawings and the following description.

EFFECTS OF THE INVENTION

According to the present technology, a difference in sensitivity of the light receiving units can be suppressed.
Note that effects described here should not be limited and there may be any one of the effects described in the present disclosure.

BRIEF DESCRIPTION OF DRAWINGS

Fig. 1 is a block diagram illustrating an embodiment of an image pickup apparatus to which the present technology is applied.

Fig. 2 is a block diagram illustrating a configuration example of a circuit of an image pickup element.

Fig. 3 is a cross-sectional view schematically illustrating a configuration example of a first embodiment not forming part of the claimed invention of the image pickup element.

Fig. 4 is a diagram illustrating a configuration example of a plasmon filter having a hole array structure.

Fig. 5 is a graph illustrating dispersion relation of surface plasmons.

Fig. 6 is a graph illustrating a first example of spectral characteristics of a plasmon filter having a hole array structure.

Fig. 7 is a graph illustrating a second example of the spectral characteristics of the plasmon filter having the hole array structure.

Fig. 8 is a graph illustrating a plasmon mode and a waveguide mode.

Fig. 9 is a graph illustrating an example of propagation characteristics of surface plasmons.

Fig. 10 is a diagram illustrating another configuration example of the plasmon filter having the hole array structure.

Fig. 11 is a diagram illustrating a configuration example of a plasmon filter having a two-layer structure.

Fig. 12 is a diagram illustrating a configuration example of a plasmon filter having a dot array structure.

Fig. 13 is a graph illustrating an example of spectral characteristics of the plasmon filter having the dot array structure.

Fig. 14 is a diagram illustrating a configuration example of a plasmon filter using GMR.

Fig. 15 is a graph illustrating an example of spectral characteristics of the plasmon filter using GMR.

Fig. 16 is a cross-sectional view schematically illustrating a configuration example of a second embodiment of the image pickup element being useful to understand the present invention.

Fig. 17 is a diagram schematically illustrating a state of occurrence of flare in the image pickup apparatus.

Fig. 18 is a view for explaining a method of reducing flare in the image pickup apparatus.

Fig. 19 is a graph illustrating a first example of spectral characteristics of a narrow band filter and a transmission filter.

Fig. 20 is a graph illustrating a second example of spectral characteristics of the narrow band filter and the transmission filter.

Fig. 21 is a graph illustrating a third example of spectral characteristics of the narrow band filter and the transmission filter.

Fig. 22 is a cross-sectional view schematically illustrating a configuration example of a third embodiment of the image pickup element being useful to understand the present invention.

Fig. 23 is a diagram illustrating a first embodiment not forming part of the claimed invention of a pixel arrangement of a pixel array.

Fig. 24 is a diagram schematically illustrating a direction of light entering the pixel array.

Fig. 25 is a diagram schematically illustrating a state of oblique light entering a pixel.

Fig. 26 is a diagram illustrating a sensitivity difference within a pixel block of a Quadra array.

Fig. 27 is a diagram illustrating a second embodiment not forming part of the claimed invention of the pixel arrangement of the pixel array.

Fig. 28 is a diagram illustrating a third embodiment forming part of the claimed invention of the pixel arrangement of the pixel array.

Fig. 29 is a diagram illustrating a fourth embodiment forming part of the claimed invention of the pixel arrangement of the pixel array.

Fig. 30 is a diagram illustrating a fifth embodiment forming part of the claimed invention of the pixel arrangement of the pixel array.

Fig. 31 is a diagram illustrating a sixth embodiment forming part of the claimed invention of the pixel arrangement of the pixel array.

Fig. 32 is a diagram illustrating a seventh embodiment forming part of the claimed invention of the pixel arrangement of the pixel array.

Fig. 33 is a diagram illustrating an example of sensitivity differences of each pixel in a pixel block of the pixel array of Fig. 32.

Fig. 34 is a diagram illustrating an eighth embodiment not forming part of the claimed invention of the pixel arrangement of the pixel array.

Fig. 35 is a diagram illustrating a ninth embodiment not forming part of the claimed invention of the pixel arrangement of the pixel array.

Fig. 36 is a diagram illustrating an outline of a configuration example of a laminated solid-state image pickup apparatus to which the present technology can be applied.

Fig. 37 is a diagram illustrating application examples of the present technology.

Fig. 38 is a table illustrating an example of detection bands in a case of detecting a flavor umami or freshness of food.

Fig. 39 is a table illustrating an example of detection bands in a case of detecting a sugar content or a moisture content of fruits.

Fig. 40 is a table illustrating an example of detection bands in a case of sorting plastics.

Fig. 41 is a diagram illustrating an example of a schematic configuration of an endoscopic surgical system.

Fig. 42 is a block diagram illustrating an example of a functional configuration of a camera head and a CCU.
Fig. 43 is a block diagram illustrating a schematic configuration example of a vehicle control system.
Fig. 44 is an explanatory diagram illustrating an example of installation positions of a vehicle exterior information detection unit and an imaging unit.

MODE FOR CARRYING OUT THE INVENTION

Note that the description will be given in the following order.

1. First embodiment
2. Second embodiment
3. Modification examples
4. Application examples

<<1. First embodiment>>

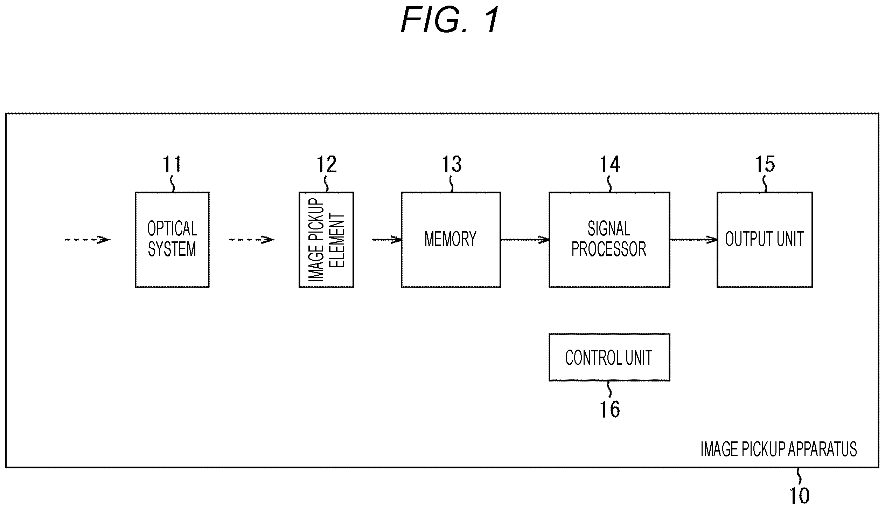

First, a first embodiment of the present technology will be described with reference to Figs. 1 to 22.

<Configuration example of image pickup apparatus>

Fig. 1 is a block diagram illustrating an embodiment of an image pickup apparatus, which is a type of an electronic device to which the present technology is applied.
An image pickup apparatus 10 of Fig. 1 is, for example, a digital camera capable of capturing both of a still image and a moving image. In addition, for example, the image pickup apparatus 10 includes a multi-spectrum camera capable of detecting light (multi-spectrum) of four or more wavelength bands (four or more bands), which is more than conventional three wavelength bands (three bands) of red (R), green (G), and blue (B) or yellow (Y), magenta (M), and cyan (C) based on three primary colors or color-matching function.
The image pickup apparatus 10 includes an optical system 11, an image pickup element 12, a memory 13, a signal processor 14, an output unit 15, and a control unit 16.
The optical system 11 includes, for example, a zoom lens, a focus lens, a diaphragm, and the like, which are not illustrated, and causes light from outside to enter the image pickup element 12. Furthermore, various filters such as a polarization filter are provided in the optical system 11 according to need.
The image pickup element 12 is, for example, a complementary metal oxide semiconductor (CMOS) image sensor. The image pickup element 12 receives incident light from the optical system 11, performs photoelectric conversion, and outputs image data corresponding to the incident light.
The memory 13 temporarily stores the image data output from the image pickup element 12.
The signal processor 14 performs signal processing (for example, processing such as noise removal, white balance adjustment, and the like) using the image data stored in the memory 13 and supplies the processed signal to the output unit 15.
The output unit 15 outputs the image data received from the signal processor 14. For example, the output unit 15 has a display (not illustrated) including liquid crystal or the like and displays a spectrum (image) corresponding to the image data from the signal processor 14, which is a so-called through image. For example, the output unit 15 includes a driver (not illustrated) for driving a recording medium such as a semiconductor memory, a magnetic disk, or an optical disk, and records the image data from the signal processor 14 to the recording medium. For example, the output unit 15 functions as a communication interface for performing communication with an unillustrated external device, and transmits the image data from the signal processor 14 to the external device wirelessly or by wire.
The control unit 16 controls each unit of the image pickup apparatus 10 according to user's operation or the like.

<Configuration example of circuit in image pickup element>

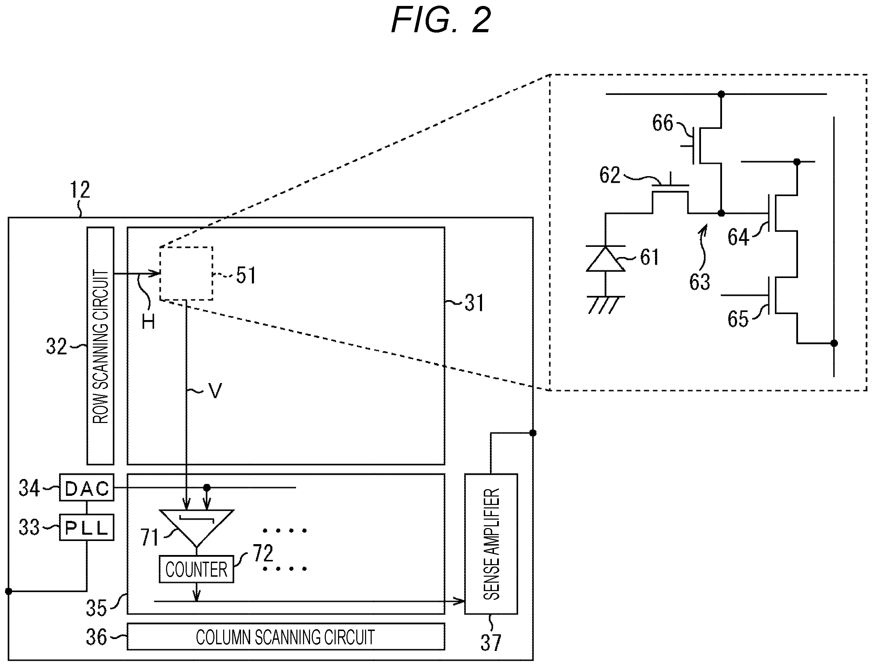

Fig. 2 is a block diagram illustrating a configuration example of a circuit in the image pickup element 12 in Fig. 1.
The image pickup element 12 includes a pixel array 31, a row scanning circuit 32, a phase locked loop (PLL) 33, a digital analog converter (DAC) 34, a column analog digital converter (ADC) circuit 35, a column scanning circuit 36, and a sense amplifier 37.
In the pixel array 31, a plurality of pixels 51 are twodimensionally arranged.
The pixel 51 is disposed at a point where the horizontal signal line H connected to the row scanning circuit 32 and the vertical signal line V connected to the column ADC circuit 35 intersect each other, and includes a photodiode 61 which performs photoelectric conversion, and several types of transistors for reading stored signals. In other words, the pixel 51 includes the photodiode 61, a transfer transistor 62, a floating diffusion 63, an amplification transistor 64, a selection transistor 65, and a reset transistor 66 as illustrated in an enlarged view on the right side in Fig. 2.

The electric charge accumulated in the photodiode 61 is transferred to the floating diffusion 63 via the transfer transistor 62. The floating diffusion 63 is connected to a gate of the amplification transistor 64. In a case where the pixel 51 is a target of signal readout, the selection transistor 65 is turned on by the row scanning circuit 32 via the horizontal signal line H, and a signal of the selected pixel 51 is read out to the vertical signal line V as a pixel signal corresponding to an accumulated charge amount of the charge accumulated in the photodiode 61 by driving a source-follower of the amplification transistor 64. Furthermore, the pixel signal is reset by turning on the reset transistor 66.

The row scanning circuit 32 sequentially outputs drive signals for driving (for example, transferring, selecting, resetting, and the like) the pixel 51 of the pixel array 31 in each row.

On the basis of a clock signal supplied from outside, the PLL 33 generates and outputs a clock signal of a predetermined frequency needed for driving each part of the image pickup element 12.

The DAC 34 generates and outputs a ramp signal of a shape (substantially a saw shape) that returns to a predetermined voltage value after voltage drops from a predetermined voltage value with a certain slope.

The column ADC circuit 35 includes a plurality of comparators 71 and counters 72 corresponding to a number of columns of the pixels 51 in the pixel array 31, extracts a signal level by performing correlated double sampling (CDS) from the pixel signal output from the pixels 51, and outputs pixel data. In other words, the comparator 71 compares the ramp signal supplied from the DAC 34 with the pixel signal (a luminance value) output from the pixel 51, and supplies a comparison result signal, which is obtained as a result, to the counter 72. Then, the counter 72 counts a counter clock signal of a predetermined frequency according to the comparison result signal output from the comparator 71 so that the pixel signal is A/D converted.

The column scanning circuit 36 sequentially supplies signals, which cause pixel data to be output, to the counter 72 of the column ADC circuit 35 at a predetermined timing.

The sense amplifier 37 amplifies the pixel data supplied from the column ADC circuit 35 and outputs the data to outside of the image pickup element 12.

<First embodiment of image pickup element>

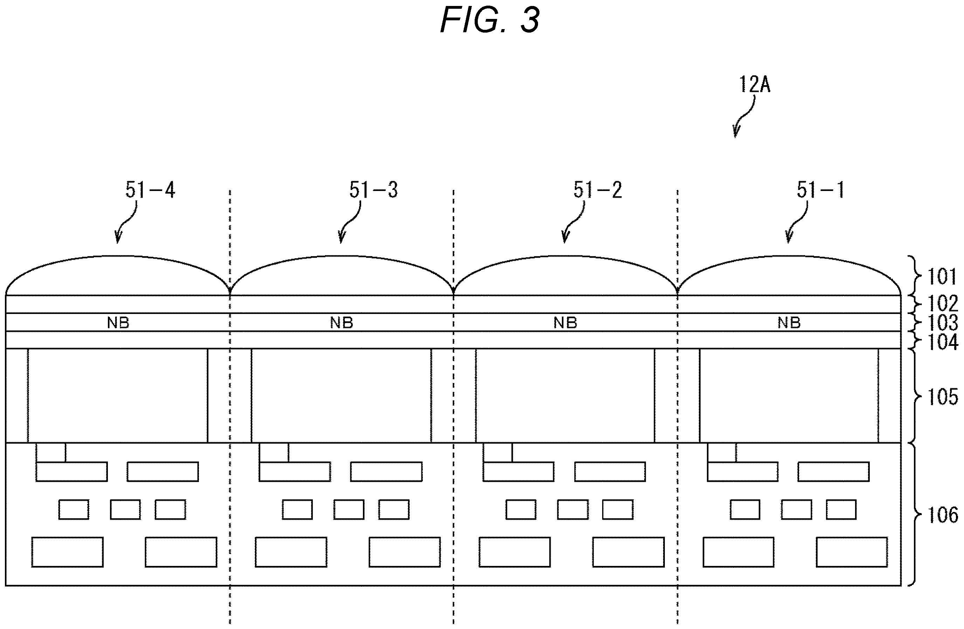

Fig. 3 schematically illustrates a cross-section configuration example of an image pickup element 12A which is a first embodiment of the image pickup element 12 of Fig. 1. Fig. 3 illustrates a cross section of four pixels, which are pixels 51-1 to 51-4 of the image pickup element 12. Note that, hereinafter, the pixels 51-1 to 51-4 are simply referred to as a pixel 51 as long as it is not necessary to distinguish the pixels 51-1 to 51-4 individually.

In each pixel 51, an on-chip microlens 101, an interlayer film 102, a narrow band filter layer 103, an interlayer film 104, a photoelectric conversion element layer 105, and a signal wiring layer 106 are laminated in order from the top. In other words, the image pickup element 12 includes a back-illuminated CMOS image sensor in which the photoelectric conversion element layer 105 is disposed on a light incident side from the signal wiring layer 106.

The on-chip microlens 101 is an optical element for collecting light to the photoelectric conversion element layer 105 of each pixel 51.

The interlayer film 102 and the interlayer film 104 include a dielectric such as $SiO_2$. As will be described later, dielectric constants of the interlayer film 102 and the interlayer film 104 are preferably made as low as possible.

In the narrow band filter layer 103, each pixel 51 is provided with a narrow band filter NB which is an optical filter that transmits a narrow band light of a predetermined narrow wavelength band (narrow band). For example, it is a type of metal thin film filter using a metal thin film such as aluminum, and a plasmon filter using surface plasmons is used for the narrow band filter NB. Furthermore, the transmission band of the narrow band filter NB is set for each pixel 51. The type (band number) of the transmission band of the narrow band filter NB is arbitrary, and is set to 4 or more, for example.

Here, the narrow band represents, for example, a wavelength band which is narrower than a transmission band of a conventional color filter of red (R), green (G), and blue (B), or yellow (Y), magenta (M), and cyan (C) based on three primary colors or color-matching function. Furthermore, in the following, a pixel that receives the narrow band light transmitted through the narrow band filter NB will be referred to as a multispectral pixel or an MS pixel.

The photoelectric conversion element layer 105 includes, for example, the photodiode 61 and the like illustrated in Fig. 2, receives light (narrow band light) transmitted through the narrow band filter layer 103 (narrow band filter NB), and converts the received light into electric charge. In addition, the photoelectric conversion element layer 105 is configured such that the respective pixels 51 are electrically separated from each other by an element separation layer.

In the signal wiring layer 106, wires and the like for reading electric charges accumulated in the photoelectric conversion element layer 105 are provided.

<About plasmon filter>

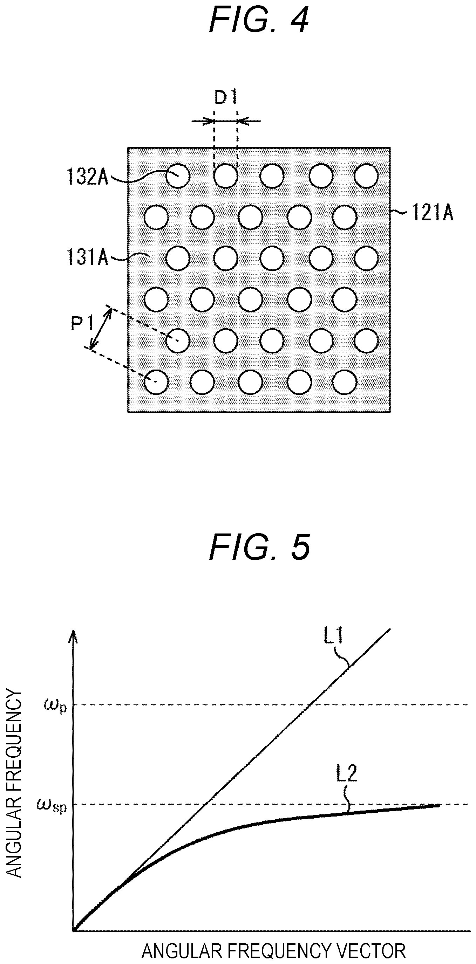

Next, with reference to Figs. 4 to 15, a plasmon filter that can be used for the narrow band filter NB will be described.

Fig. 4 illustrates a configuration example of a plasmon filter 121A having a hole array structure.

The plasmon filter 121A includes a plasmon resonator in which holes 132A are arranged in a honeycomb form in a thin metal film (hereinafter, referred to as a conductor thin film) 131A.

Each hole 132A penetrates the conductor thin film 131A and functions as a waveguide. In the waveguide, generally, a cutoff frequency and a cutoff wavelength, which are determined by a shape such as a side length and a diameter, are set, and there is a property that light having a frequency equal to or lower than the cutoff frequency (or wavelengths equal to or greater than the cutoff wavelength) is not transmitted. The cutoff wavelength of the hole 132A mainly depends on the opening diameter D1, and in a case where the opening diameter D1 becomes smaller, the cutoff wavelength becomes shorter. Here, the opening diameter D1 is set to a value smaller than the wavelength of light to be transmitted.

On the other hand, in a case where light enters the conductor thin film 131A in which the holes 132A are formed at regular intervals with a short period equal to or shorter than the wavelength of the light, this causes a phenomenon that light having a longer wavelength than the cutoff wavelength of the hole 132A is transmitted. This phenomenon is called an abnormal transmission phenomenon of plasmon. This phenomenon is caused by surface plasmons excitation at the boundary between the conductor thin film 131A and the interlayer film 102 in an upper layer.

Here, with reference to Fig. 5, the generation condition of abnormal transmission phenomenon (surface plasmon resonance) of plasmon will be described.

Fig. 5 is a graph illustrating dispersion relation of surface plasmons. The horizontal axis of the graph indicates angular frequency vector k and vertical axis indicates the angular frequency $\omega$. $\omega_p$ represents plasma frequency of the conductor thin film 131A. $\omega_{sp}$ represents surface plasma frequency at the interface between the interlayer film 102 and the conductor thin film 131A, and is expressed as the following equation (1).

[Equation 1]

$$\omega_{sp} = \frac{\omega_p}{\sqrt{1 + \varepsilon_d}} \qquad \cdots (1)$$

$\varepsilon_d$ represents dielectric constant of the dielectric constituting the interlayer film 102.

From equation (1), the surface plasma frequency $\omega_{sp}$ increases as the plasma frequency $\omega_p$ increases. Furthermore, the surface plasma frequency $\omega_{sp}$ increases as the dielectric constant $\varepsilon_d$ decreases.

The line L1 indicates a light dispersion relation (light line) and is expressed by the following equation (2).

[Equation 2]

$$\omega = \frac{c}{\sqrt{\varepsilon_d}} k \qquad \cdots (2)$$

c represents speed of light.

The line L2 indicates a dispersion relation of the surface plasmons and is expressed by the following equation (3).

[Equation 3]

$$\omega = ck \sqrt{\frac{\varepsilon_m + \varepsilon_d}{\varepsilon_m \varepsilon_d}} \qquad \cdots (3)$$

$\varepsilon_m$ represents dielectric constant of the conductor thin film 131A.

In a range where the angular frequency vector k is small, the dispersion relation of the surface plasmons indicated by the line L2 gradually approaches the light line indicated by the line L1 and gradually approaches the surface plasma frequency $\omega_{sp}$ as the angular wave vector k increases.

Then, in a case where the following equation (4) is satisfied, an abnormal transmission phenomenon of plasmon occurs.

[Equation 4]

$$\mathrm{Re}\left[\frac{\omega_{sp}}{c}\sqrt{\frac{\varepsilon_m \varepsilon_d}{\varepsilon_m + \varepsilon_d}}\right] = \left|\frac{2\pi}{\lambda}\sin\theta + iG_x + jG_y\right| \quad \cdots (4)$$

X represents a wavelength of incident light. $\theta$ represents an entering angle of incident light. $G_x$ and $G_y$ are expressed by the following equation (5).

$$|G_x| = |G_y| = 2\pi/a_0 \quad \cdots (5)$$

$a_0$ represents a lattice constant of the hole array structure including the holes 132A of the conductor thin film 131A.

The left side of the equation (4) indicates the angular wave vector of the surface plasmons, and the right side indicates the angular frequency vector of the hole array period of the conductor thin film 131A. Therefore, in a case where the angular wave vector of the surface plasmons and the angular frequency vector of the hole array period of the conductor thin film 131A become equal, an abnormal transmission phenomenon of the plasmon occurs. Then, the value of $\lambda$ at this time is the resonance wavelength of the plasmon (the transmission wavelength of the plasmon filter 121A).

Note that the angular frequency vector of the surface plasmons on the left side of the equation (4) is determined by the dielectric constant $\varepsilon_m$ of the conductor thin film 131A and the dielectric constant $\varepsilon_d$ of the interlayer film 102. On the other hand, the angular frequency vector of the hole array period on the right side is determined by the light incident angle $\theta$ and the pitch (hole pitch) P1 between adjacent holes 132A of the conductor thin film 131A. Therefore, the resonance wavelength and the resonance frequency of the plasmon are determined by the dielectric constant $\varepsilon_m$ of the conductor thin film 131A, the dielectric constant $\varepsilon_d$ of the interlayer film 102, the incident angle $\theta$ of light, and the hole pitch P1. Here, in a case where the entering angle of light is 0°, the resonance wavelength and the resonance frequency of the plasmon are determined by the dielectric constant $\varepsilon_m$ of the conductor thin film 131A, the dielectric constant $\varepsilon_d$ of the interlayer film 102, and the hole pitch P1.

Therefore, the transmission band (resonance wavelength of plasmon) of the plasmon filter 121A varies according to the material and thickness of the conductor thin film 131A, the material and thickness of the interlayer film 102, the pattern period of the hole array (for example, an opening diameter D1 and a hole pitch P1 of the hole 132A) and the like. In particular, in a case where the material and thickness of the conductor thin film 131A and the interlayer film 102 have been determined, the transmission band of the plasmon filter 121A varies according to the pattern period of the hole array, particularly the hole pitch P1. In other words, as the hole pitch P1 becomes narrower, the transmission band of the plasmon filter 121A shifts to the shorter wavelength side, and as the hole pitch P1 becomes wider, the transmission band of the plasmon filter 121A shifts to the longer wavelength side.

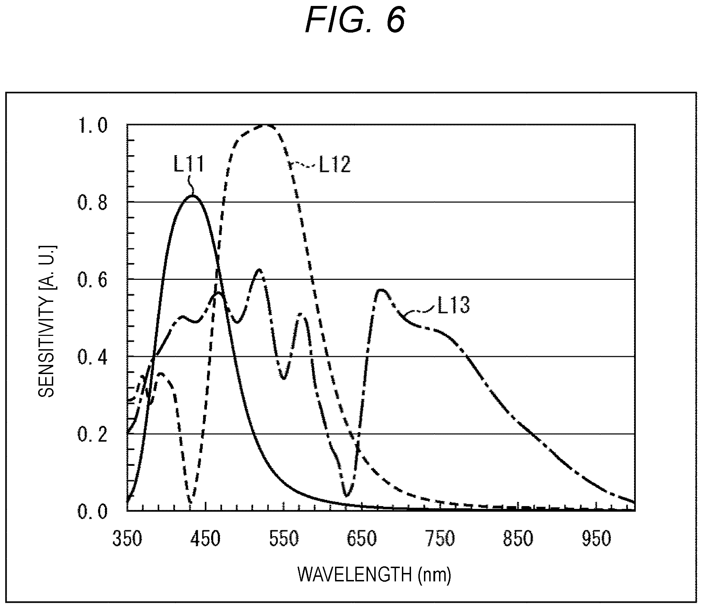

Fig. 6 is a graph illustrating an example of spectral characteristics of the plasmon filter 121A in a case where the hole pitch P1 is changed. The horizontal axis of the graph indicates wavelength (the unit is nm) and the vertical axis indicates sensitivity (the unit is arbitrary unit). The line L11 indicates spectral characteristics in a case where the hole pitch P1 is set to 250 nm, the line L12 indicates spectral characteristics in a case where the hole pitch P1 is set to 325 nm, and the line L13 indicates spectral characteristics in a case where the hole pitch P1 is set to 500 nm.

In a case where the hole pitch P1 is set to 250 nm, the plasmon filter 121A mainly transmits light in a blue wavelength band. In a case where the hole pitch P1 is set to 325 nm, the plasmon filter 121A mainly transmits light in a green wavelength band. In a case where the hole pitch P1 is set to 500 nm, the plasmon filter 121A mainly transmits light in a red wavelength band. However, in a case where the hole pitch P1 is set to 500 nm, the plasmon filter 121A transmits a large amount of light in a band having a wavelength lower than that of red by a later described waveguide mode.

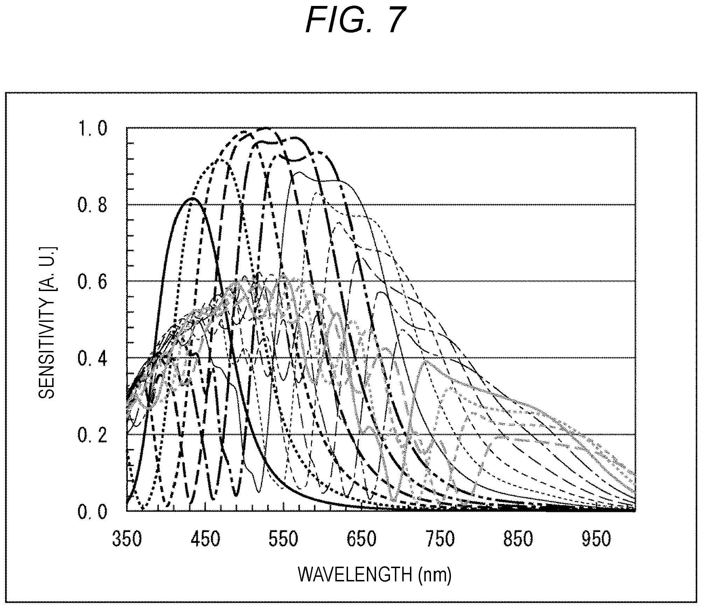

Fig. 7 is a graph illustrating another example of the spectral characteristics of the plasmon filter 121A in a case where the hole pitch P1 is changed. The horizontal axis of the graph indicates wavelength (the unit is nm) and the vertical axis indicates sensitivity (the unit is arbitrary unit). This example describes an example of spectral characteristics of the sixteen kinds of plasmon filter 121A in a case where the hole pitch P1 is changed from 250 nm to 625 nm by the units of 25 nm.

Note that the transmittance of the plasmon filter 121A is mainly determined by the opening diameter D1 of the hole 132A. As the opening diameter D1 increases, the transmittance increases and color mixing is likely to occur. In general, it is desirable to set the opening diameter D1 so that the opening ratio becomes 50% to 60% of the hole pitch P1.

Furthermore, as described above, each hole 132A of the plasmon filter 121A serves as a waveguide. Therefore, depending on the pattern of the hole array of the plasmon filter 121A, in the spectral characteristics, not only the wavelength component (wavelength component in the plasmon mode) transmitted by the surface plasmon resonance but also the wavelength component (wavelength component in the plasmon mode) transmitted through the hole 132A (waveguide) may increase in some cases.

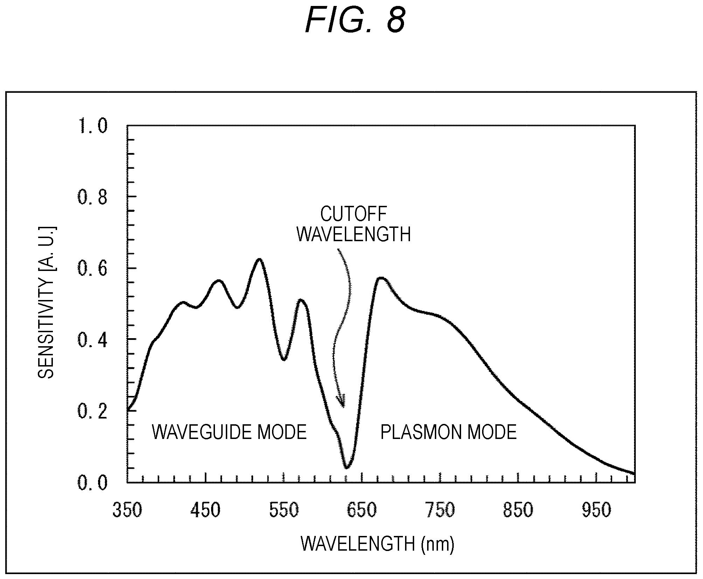

Fig. 8 illustrates spectral characteristics of the plasmon filter 121A in a case where the hole pitch P1 is set to 500 nm, as in the spectral characteristic indicated by the line L13 in Fig. 6. In this example, the longer wavelength side than the cutoff wavelength in the vicinity of 630 nm is the wavelength component in the plasmon mode and the shorter wavelength side than the cutoff wavelength is the wavelength component in the waveguide mode.

As described above, the cutoff wavelength mainly depends on the opening diameter D1 of the hole 132A and, in a case where the opening diameter D1 is smaller, the cutoff wavelength becomes shorter. Then, as the difference between the cutoff wavelength and the peak wavelength in the plasmon mode is increased, the wavelength resolution characteristic of the plasmon filter 121A is improved.

Furthermore, as described above, as the plasma frequency $\omega_p$ of the conductor thin film 131A increases, the surface plasma frequency $\omega_{sp}$ of the conductor thin film 131A increases. In addition, as the dielectric constant $\varepsilon_d$ of the interlayer film 102 decreases, the surface plasma frequency $\omega_{sp}$ increases. Then, as the surface plasma frequency $\omega_{sp}$ increases, the resonance frequency of the plasmon can be set higher and the transmission band (plasmon resonance wavelength) of the plasmon filter 121A can be set to a shorter wavelength band.

Therefore, in a case where a metal having a smaller plasma frequency $\omega_p$ is used for the conductor thin film 131A, the transmission band of the plasmon filter 121A can be set to a shorter wavelength band. For example, aluminum, silver, gold, and the like are preferable. However, in a case where the transmission band is set to a long wavelength band such as infrared light, copper or the like can also be used.

Furthermore, in a case where a dielectric having a smaller dielectric constant $\varepsilon_d$ is used for the interlayer film 102, the transmission band of the plasmon filter 121A can be set to a shorter wavelength band. For example, SiO2, Low-K, or the like is preferable.

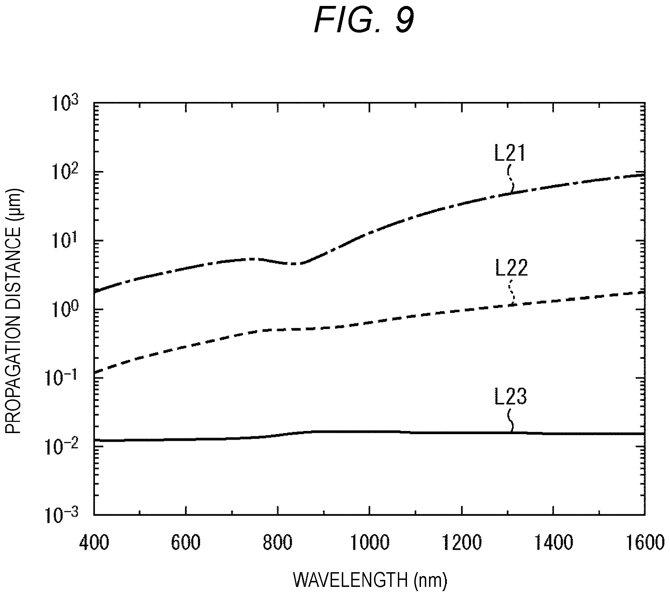

Furthermore, Fig. 9 is a graph illustrating propagation characteristics of the surface plasmons at the interface between the conductor thin film 131A and the interlayer film 102 in a case where aluminum is used for the conductive thin film 131A and SiO2 is used for the interlayer film 102. The horizontal axis of the graph indicates light wavelength of (the unit is nm) and the vertical axis indicates propagation distance (the unit is $\mu$m). Furthermore, the line L21 indicates propagation characteristic in the interface direction, the line L22 indicates the propagation characteristic in the depth direction (the direction perpendicular to the interface) of the interlayer film 102, the line L23 indicates propagation characteristic in the depth direction of the conductor thin film 131A (the direction perpendicular to the interface).

The propagation distance $\Lambda_{SPP}(\lambda)$ in the depth direction of the surface plasmons is expressed by the following equation (6).

[Equation 5]

$$\Lambda_{SPP}(\lambda) \equiv \frac{4\pi k_{SPP}}{\lambda} = \frac{4\pi}{\lambda} \mathrm{Im}\left[\sqrt{\frac{\varepsilon_m \varepsilon_d}{\varepsilon_m + \varepsilon_d}}\right] \quad \cdots (6)$$

$k_{SPP}$ represents an absorption coefficient of a material through which surface plasmons propagate. $\varepsilon_m(\lambda)$ represents a dielectric constant of the conductor thin film 131A with respect to the light having the wavelength $\lambda$. $\varepsilon_d(\lambda)$ represents a dielectric constant of the interlayer film 102 with respect to the light having the wavelength $\lambda$.

Therefore, as illustrated in Fig. 9, the surface plasmons for light with a wavelength of 400 nm are transmitted from the surface of the interlayer film 102 including SiO2 to about 100 nm in the depth direction. Therefore, in a case where the thickness of the interlayer film 102 is set to 100 nm or more, this prevents the surface plasmons at the interface between the interlayer film 102 and the conductor thin film 131A from being affected by a substance laminated on the surface of the interlayer film 102 on the side opposite to the conductor thin film 131A.

Furthermore, the surface plasmons for the light with the wavelength of 400 nm propagate from the surface of the conductor thin film 131A including aluminum to about 10 nm in the depth direction. Therefore, in a case where the thickness of the conductor thin film 131A is set to 10 nm or more, this prevents the surface plasmons at the interface between the interlayer film 102 and the conductor thin film 131A from being affected by an influence of the interlayer film 104.

<Another example of plasmon filter>

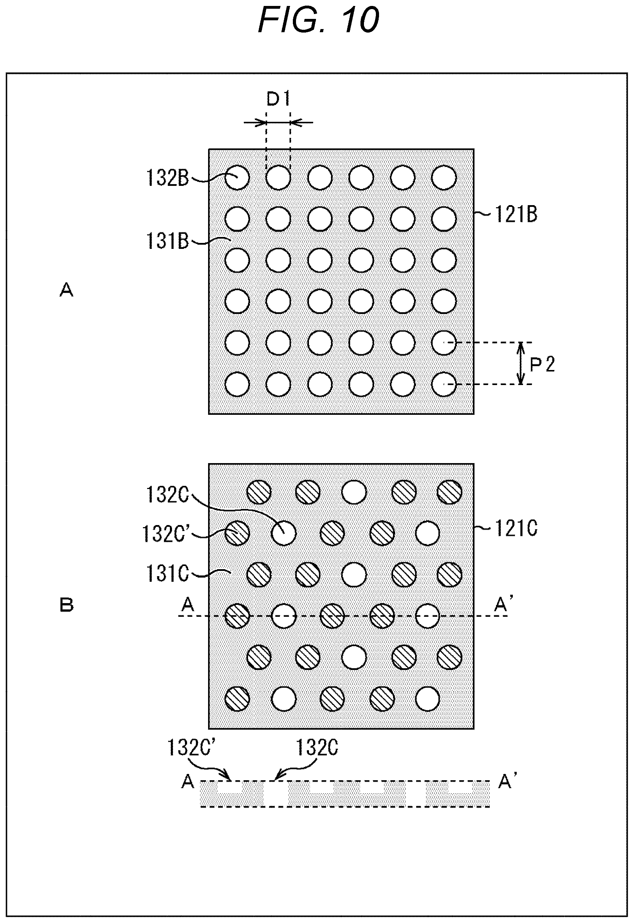

Next, another example of the plasmon filter will be described with reference to Figs. 10 to 15.

The plasmon filter 121B in A of Fig. 10 includes a plasmon resonator in which holes 132B are arranged in a direct matrix form in the conductor thin film 131B. In the plasmon filter 121B, for example, the transmission band changes according to the pitch P2 between adjacent holes 132B.

Furthermore, in the plasmon resonator, all of the holes do not have to penetrate through the conductor thin film, and the plasmon resonator can function as a filter even in a case where some of the holes are formed by non-through holes, which do not penetrate the conductive thin film.

For example, B of Fig. 10 illustrates a plan view and a sectional view (a sectional view taken along the line A-A' in the plan view) of a plasmon filter 121C including a plasmon resonator in which a hole 132C including a through hole and a hole 132C' including a non-through hole are arranged in a honeycomb form in the conductor thin film 131C. In other words, in the plasmon filter 121C, the hole 132C including a through hole and the hole 132C' including a non-through hole are arranged at regular intervals.

Furthermore, a plasmon resonator of a single layer is basically used as the plasmon filter; however, for example, a two-layer plasmon resonator may be used.

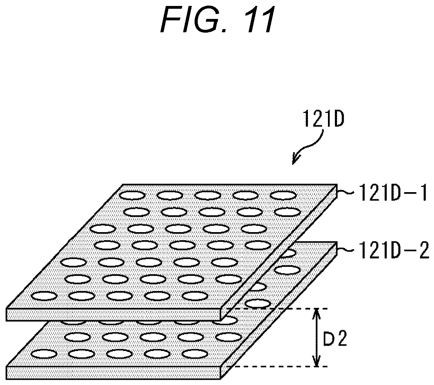

For example, a plasmon filter 121D illustrated in Fig. 11 includes a two-layer plasmon filter 121D-1 and a plasmon filter 121D-2. The plasmon filter 121D-1 and the plasmon filter 121D-2 have a structure in which holes are arranged in a honeycomb structure as in the plasmon resonator constituting the plasmon filter 121A in Fig. 4.

In addition, the distance D2 between the plasmon filter 121D-1 and the plasmon filter 121D-2 is preferably about 1/4 the peak wavelength of the transmission band. Furthermore, in consideration of flexibility of design, the distance D2 is more preferably 1/2 or less of the peak wavelength of the transmission band.

Here, in addition to arranging the holes in a same pattern in the plasmon filter 121D-1 and the plasmon filter 121D-2 as in the plasmon filter 121D, for example, the holes may be arranged in a pattern similar to each other in the two-layer plasmon resonator structure. Furthermore, in the two-layer plasmon resonator structure, holes and dots may be arranged in a pattern such that a hole array structure and a dot array structure (described later) are reversed. Furthermore, the plasmon filter 121D has a two-layer structure; however, three or more layers can be used.

Furthermore, the configuration example of the plasmon filter using the plasmon resonator of the hole array structure has been described above; however, a plasmon resonator of the dot array structure may be employed as the plasmon filter.

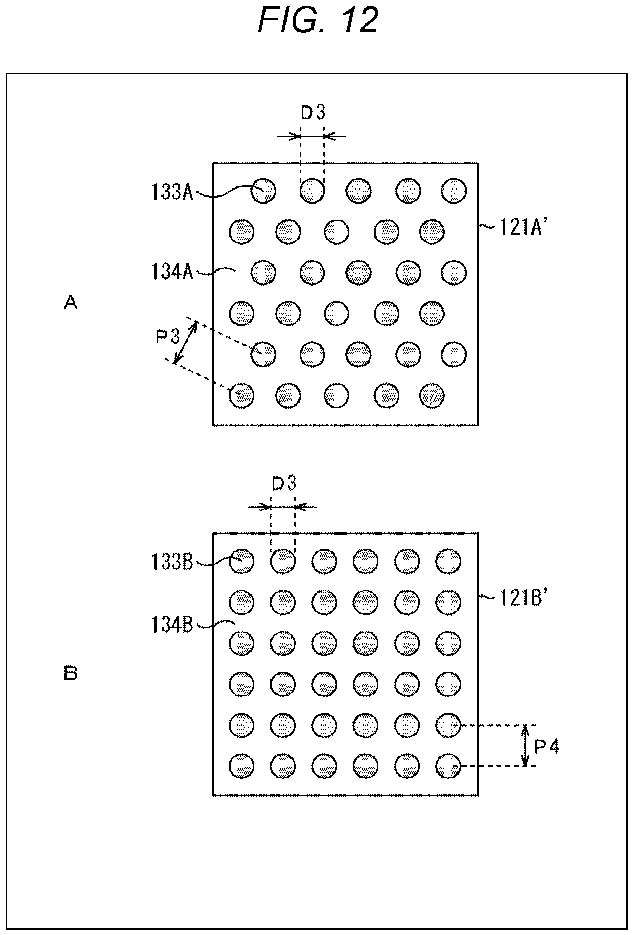

With reference to Fig. 12, a plasmon filter having a dot array structure will be described.

A plasmon filter 121A' in A of Fig. 12 has a structure that is negative/positive inversion with respect to the plasmon resonator of the plasmon filter 121A in Fig. 4, that is, a plasmon resonator having dots 133A arranged in a honeycomb form on a dielectric layer 134A. A space between the respective dots 133A is filled with the dielectric layer 134A.

The plasmon filter 121A' absorbs light of a predetermined wavelength band and is therefore used as a complementary color filter. The wavelength band (hereinafter, referred to as an absorption band) of light absorbed by the plasmon filter 121A' varies depending on the pitch P3 between adjacent dots 133A (hereinafter, referred to as a dot pitch) and the like. Furthermore, the diameter D3 of the dot 133A is adjusted in accordance with the dot pitch P3.

A plasmon filter 121B' in B of Fig. 12 has a structure that is negative/positive inversion with respect to the plasmon resonator of the plasmon filter 121B in A of Fig. 10, that is, the plasmon resonance structure in which dots 133B are arranged in a direct matrix form on a dielectric layer 134B. A space between the respective dots 133B is filled with the dielectric layer 134B.

An absorption band of the plasmon filter 121B' varies depending on the dot pitch P4 between adjacent dots 133B and the like. Furthermore, the diameter D3 of the dot 133B is adjusted in accordance with the dot pitch P4.

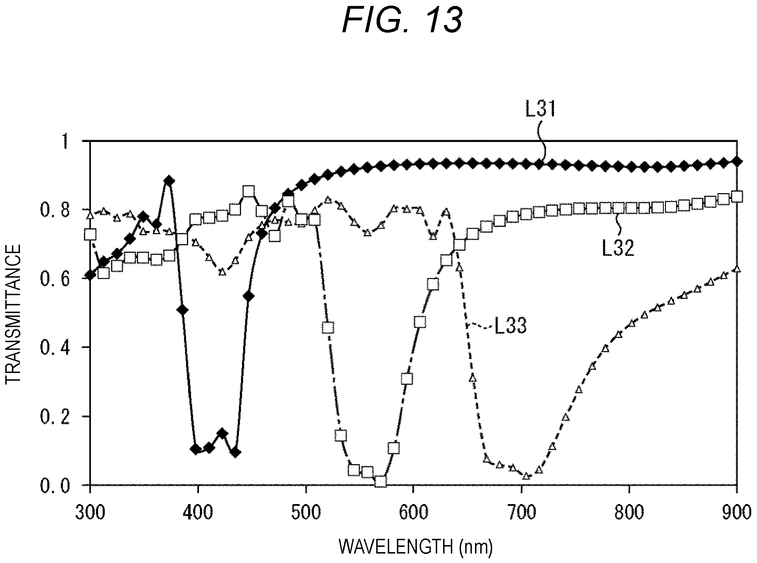

Fig. 13 is a graph illustrating an example of spectral characteristics in a case where the dot pitch P3 of the plasmon filter 121A' in A of Fig. 12 is changed. The horizontal axis of the graph indicates wavelength (the unit is nm) and the vertical axis indicates transmittance. The line L31 indicates spectral characteristics in a case where the dot pitch P3 is set to 300 nm, the line L32 indicates spectral characteristics in a case where the dot pitch P3 is set to 400 nm, and the line L33 indicates spectral characteristics in a case where the dot pitch P3 is set to 500 nm.

As illustrated in this diagram, as the dot pitch P3 becomes narrower, the absorption band of the plasmon filter 121A' shifts to the shorter wavelength side and, as the dot pitch P3 becomes wider, the absorption band of the plasmon filter 121A' shifts to the longer wavelength side.

Here, in any of the plasmon filters of the hole array structure and the dot array structure, the transmission band or the absorption band can be adjusted simply by adjusting the pitch in the planar direction of the holes or dots. Therefore, for example, by merely adjusting the pitch of the holes or dots in the lithography process, the transmission band or the absorption band can be individually set for each pixel, and the filter can be multicolored in fewer steps.

Furthermore, the thickness of the plasmon filter is about 100 to 500 nm which is practically similar to that of the organic material type color filter, and has preferable process compatibility.

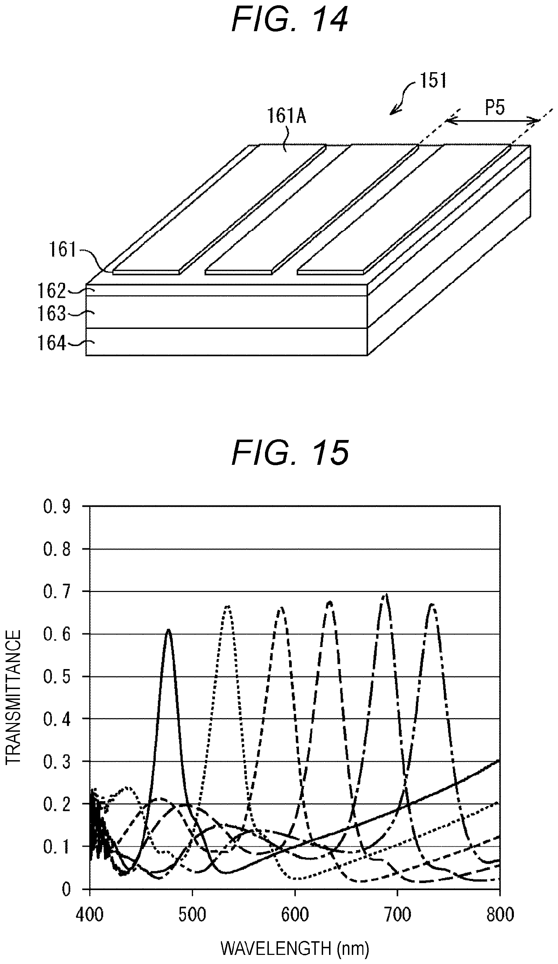

Furthermore, for the narrow band filter NB, a plasmon filter 151 using guided mode resonant (GMR) illustrated in Fig. 14 can be used.

In the plasmon filter 151, a conductor layer 161, a SiO2 film 162, a SiN film 163, and a SiO2 substrate 164 are laminated in order from the top. For example, the conductor layer 161 is included in the narrow band filter layer 103 in Fig. 3, and the SiO2 film 162, the SiN film 163, and the SiO2 substrate 164 are included, for example, in the interlayer film 104 in Fig. 3.

In the conductor layer 161, for example, rectangular conductor thin films 161A including aluminum are arranged at a predetermined pitch P5 so that longitudinal sides of the conductor thin films 161A are adjacent to each other. Then, the transmission band of the plasmon filter 151 varies depending on the pitch P5 or the like.

Fig. 15 is a graph illustrating an example of spectral characteristics of the plasmon filter 151 in a case where the pitch P5 is changed. The horizontal axis of the graph indicates wavelength (the unit is nm) and the vertical axis indicates transmittance. This example describes spectral characteristics in a case where the pitch P5 is changed from 280 nm to 480 nm in six levels by increments of 40 nm and the width of a slit between the adjacent conductor thin films 161A is set to 1/4 of the pitch P5. Furthermore, the waveform having the shortest peak wavelength of the transmission band indicates spectral characteristics in a case where the pitch P5 is set to 280 nm, and the peak wavelength becomes longer as the pitch P5 becomes wider. In other words, as the pitch P5 becomes narrower, the transmission band of the plasmon filter 151 shifts to the short wavelength side and, as the pitch P5 becomes wider, the transmission band of the plasmon filter 151 shifts to the long wavelength side.

The plasmon filter 151 using this GMR also has preferable compatibility with the organic material type color filter as in the described above plasmon filter of the hole array structure and dot array structure.

<Second embodiment of image pickup element>

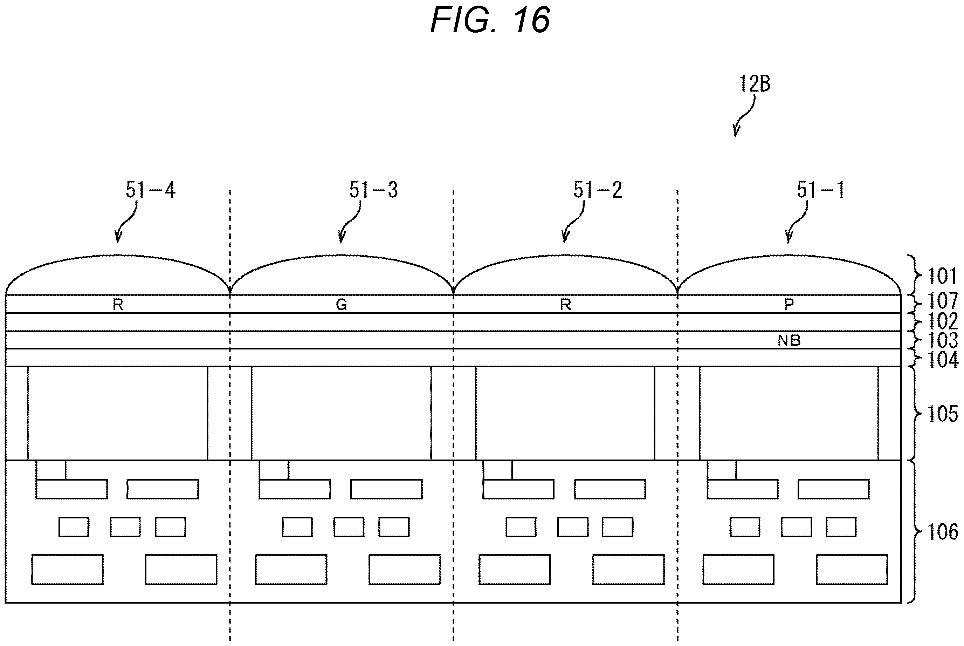

Next, with reference to Figs. 16 to 21, a second embodiment of the image pickup element 12 of Fig. 1 will be described.

Fig. 16 schematically illustrates a configuration example of a cross section of an image pickup element 12B which is the second embodiment of the image pickup element 12. Here, in the drawing, parts corresponding to those of the image pickup element 12A in Fig. 3 are denoted by the same reference numerals, and the description thereof will be omitted as appropriate.

The image pickup element 12B is different from the image pickup element 12A in that a color filter layer 107 is laminated between the on-chip microlens 101 and the interlayer film 102.

In the narrow band filter layer 103 of the image pickup element 12B, the narrow band filter NB is provided only in some of the pixels 51, not all the pixels 51. The type (band number) of the transmission band of the narrow band filter NB is arbitrary, and may be set to one or more, for example.

A color filter is provided in each pixel 51 in the color filter layer 107. For example, in the pixel 51, which does not include the narrow band filter NB, any one of the general red filter R, green filter G, and blue filter B (not illustrated) is provided. With this configuration, for example, an R pixel provided with the red filter R, a G pixel provided with the green filter G, a B pixel provided with the blue filter, and an MS pixel provided with the narrow band filter NB are connected to the pixel array 31.

Furthermore, in the pixel 51 provided with the narrow band filter NB, the transmission filter P is provided in the color filter layer 107. As will be described later, the transmission filter P includes an optical filter (a low-pass filter, a high-pass filter, or a band-pass filter) that transmits light in a wavelength band including the transmission band of the narrow band filter NB of the same pixel 51.

Note that the color filter provided in the color filter layer 107 may be any one of an organic material type and an inorganic material type.

For example, as the organic material type color filter, there are a dyeing and coloring system using a synthetic resin or a natural protein, and a pigment-containing system using a pigment dye or a dye coloring matter.

For an inorganic material type color filter, for example, materials such as $TiO_2$, ZnS, SiN, $MgF_2$, $SiO_2$, and Low-k, are used. Furthermore, methods such as deposition, sputtering, and chemical vapor deposition (CVD) film formation, are used for forming the inorganic material-based color filter, for example.

Furthermore, as described above with reference to Fig. 9, the interlayer film 102 has a film thickness that can prevent the influence of the color filter layer 107 from being exerted on the surface plasmons at the interface between the interlayer film 102 and the narrow band filter layer 103.

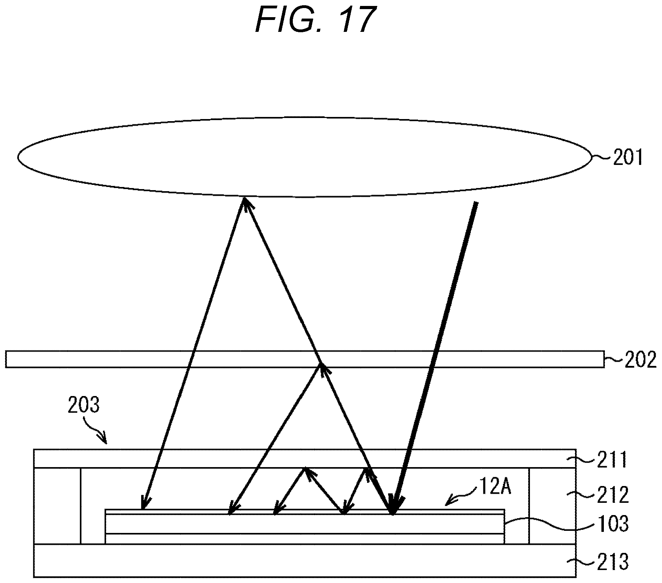

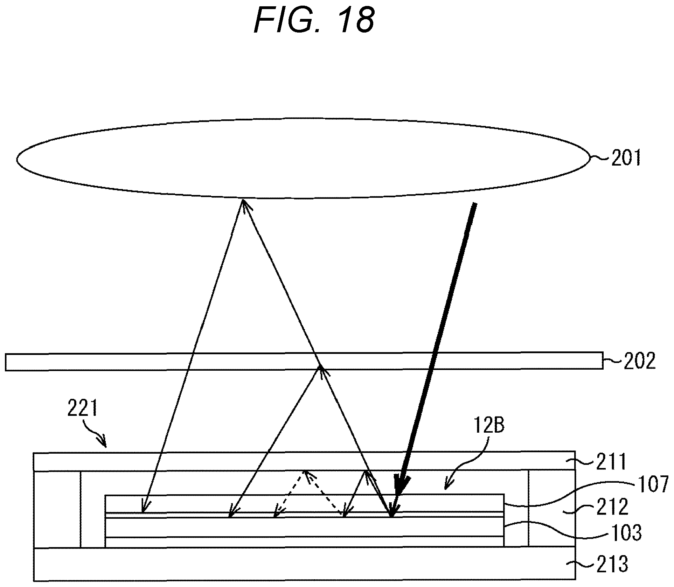

Here, occurrence of flare is suppressed by the transmission filter P provided in the color filter layer 107. This point will be described with reference to Figs. 17 and 18.

Fig. 17 schematically illustrates occurrence of flare in the image pickup apparatus 10 using the image pickup element 12A of Fig. 2 without the color filter layer 107.

In this example, the image pickup element 12A is provided in a semiconductor chip 203. Specifically, the semiconductor chip 203 is mounted on a substrate 213, and the periphery thereof is covered with a seal glass 211 and a resin 212. Then, the light transmitted through the lens 201, the IR cut filter 202, and the seal glass 211 provided in the optical system 11 in Fig. 1 enters the image pickup element 12A.

Here, in a case where the narrow band filter NB of the narrow band filter layer 103 of the image pickup element 12A includes a plasmon filter, a metallic conductor thin film is formed on the plasmon filter. Since this conductor thin film has high reflectance, light of wavelengths other than the transmission band is easily reflected. Then, a part of the light reflected by the conductor thin film is reflected by the seal glass 211, the IR cut filter 202, or the lens 201, for example, as illustrated in Fig. 17, and reenters the image pickup element 12A. Flare is generated by these re-incident light. A plasmon filter having a hole array structure particularly has a low aperture ratio, and flare is likely to be generated.

In order to prevent this reflected light, for example, it is conceivable to use an antireflection film including a metal different from the conductor thin film or a material having a high dielectric constant. However, the plasmon filter uses surface plasmon resonance and, in a case where such an antireflection film touches the surface of the conductor thin film, the characteristics of the plasmon filter deteriorate or desired characteristics may become hard to obtain.

On the other hand, Fig. 18 schematically illustrates how flare is generated in the image pickup apparatus 10 having the image pickup element 12B of Fig. 16 provided with the color filter layer 107. Here, in the drawing, parts corresponding to those in Fig. 17 are denoted by the same reference numerals.

The example of Fig. 18 is different from the example of Fig. 17 in that a semiconductor chip 221 is provided as a substitute for the semiconductor chip 203. The semiconductor chip 221 differs from the semiconductor chip 203 in that an image pickup element 12B is provided as a substitute for the image pickup element 12A.

As described above, in the image pickup element 12B, a transmission filter P is provided above the narrow band filter NB (in a light entering side). Therefore, the light entering the image pickup element 12B enters the narrow band filter NB after the predetermined wavelength band is blocked by the transmission filter P, so that the amount of light entering the narrow band filter NB is suppressed. As a result, the amount of light reflected by the conductor thin film of the narrow band filter NB (plasmon filter) is also reduced, and this reduces flare.

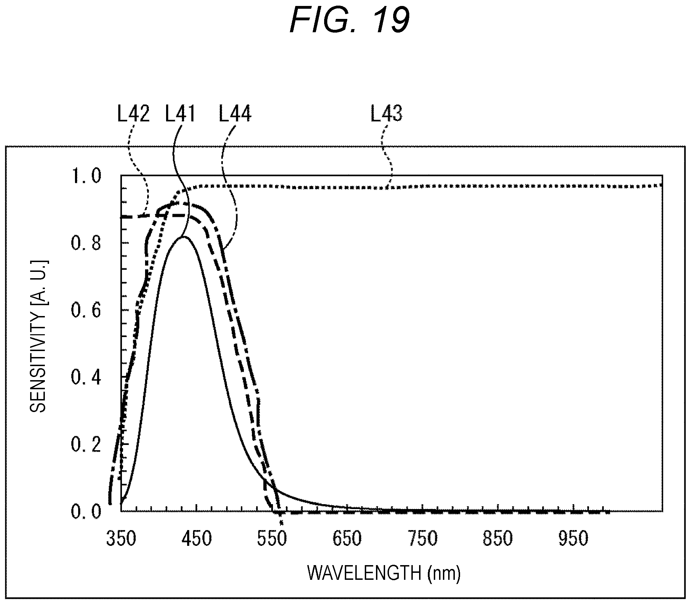

Figs. 19 to 21 illustrate examples of spectral characteristics of the narrow band filter NB and spectral characteristics of the transmission filter P arranged above the narrow band filter NB. Here, in the graphs of Figs. 19 to 21, the horizontal axis indicates wavelength (the unit is nm) and the vertical axis indicates sensitivity (the unit is arbitrary unit).

The line L41 in Fig. 19 indicates spectral characteristics of the narrow band filter NB. The peak wavelength of the spectral characteristic of the narrow band filter NB is around 430 nm. The line L42 indicates spectral characteristics of a low pass type transmission filter P. The line L43 indicates spectral characteristics of a high pass type transmission filter P. The line L44 indicates spectral characteristics of a band pass type transmission filter P. The sensitivity of any of the transmission filters P exceeds the sensitivity of the narrow band filter NB in a predetermined wavelength band including the peak wavelength of the spectral characteristic of the narrow band filter NB. Therefore, with any of the transmission filters P, the amount of incident light entering the narrow band filter NB can be reduced without substantially attenuating the light in the transmission band of the narrow band filter NB.

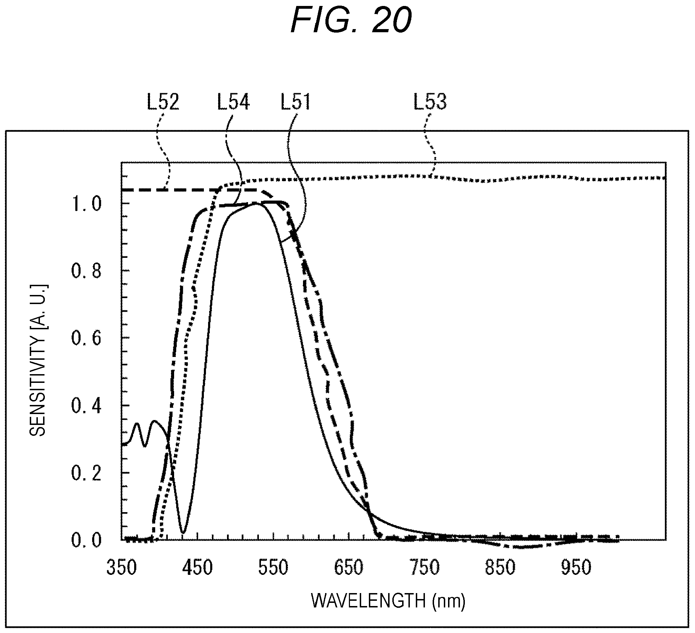

The line L51 in Fig. 20 indicates spectral characteristics of the narrow band filter NB. The peak wavelength of the spectral characteristics of the narrow band filter NB is around 530 nm. The line L52 indicates spectral characteristics of the low pass type transmission filter P. The line L53 indicates spectral characteristics of the high pass type transmission filter P. The line L54 indicates spectral characteristics of the band pass type transmission filter P. The sensitivity of any of the transmission filters exceeds the sensitivity of the narrow band filter NB in a predetermined wavelength band including the peak wavelength of the spectral characteristics of the narrow band filter NB. Therefore, with any of the transmission filters P, the amount of incident light entering the narrow band filter NB can be reduced without substantially attenuating the light in the transmission band of the narrow band filter NB.

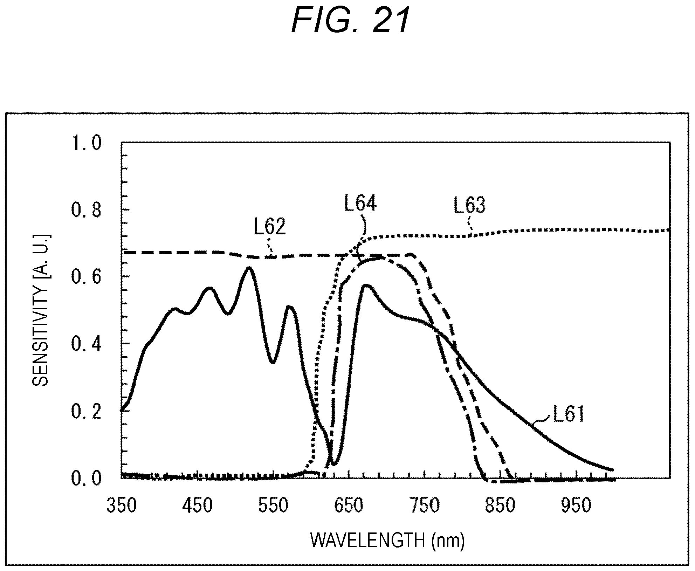

The line L61 in Fig. 21 indicates spectral characteristics of the narrow band filter NB. The peak wavelength of the spectral characteristic of the narrow band filter NB in the plasmon mode is around 670 nm. The line L62 indicates spectral characteristics of the low pass type transmission filter P. The line L63 indicates spectral characteristics of the high pass type transmission filter P. The line L64 indicates spectral characteristics of the band pass type transmission filter P. The sensitivity of any of the transmission filters P exceeds the sensitivity of the narrow band filter NB in a predetermined wavelength band including the peak wavelength of the plasmon mode of about 630 nm or more which is the cutoff wavelength of the spectral characteristics of the narrow band filter NB. Therefore, with any one of the transmission filter P, the amount of incident light entering the narrow band filter NB can be reduced without substantially attenuating the light in the transmission band in the plasmon mode of the narrow band filter NB. However, it is more preferable to use the high pass type or band pass type transmission filter P in view of narrow band filter characteristics since light having the wavelength band in the waveguide mode of the narrow band filter NB can be blocked.

Here, in a case where the transmission band of the red filter R, the green filter G, or the blue filter B includes the transmission band of the lower-layer narrow band filter NB, these filters may be used for the transmission filter P.

Furthermore, in the example of Fig. 16, the narrow band filter NB is provided only in some of the pixels 51; however, the narrow band filter NB may be provided in all the pixels 51. In this case, for each pixel 51, a transmission filter P having a transmission band including the transmission band of the narrow band filter NB of the pixel 51 may be provided in the color filter layer 107.

Furthermore, the color combination of the color filter of the color filter layer 107 is not limited to the above described example, and modification can be made according to need.

In addition, in a case where it is not necessary to take measures against the above described flare, for example, the transmission filter P may not be provided on the upper layer of the narrow band filter NB or a dummy filter that transmits light of all wavelengths may be provided.

<Third embodiment of image pickup element>

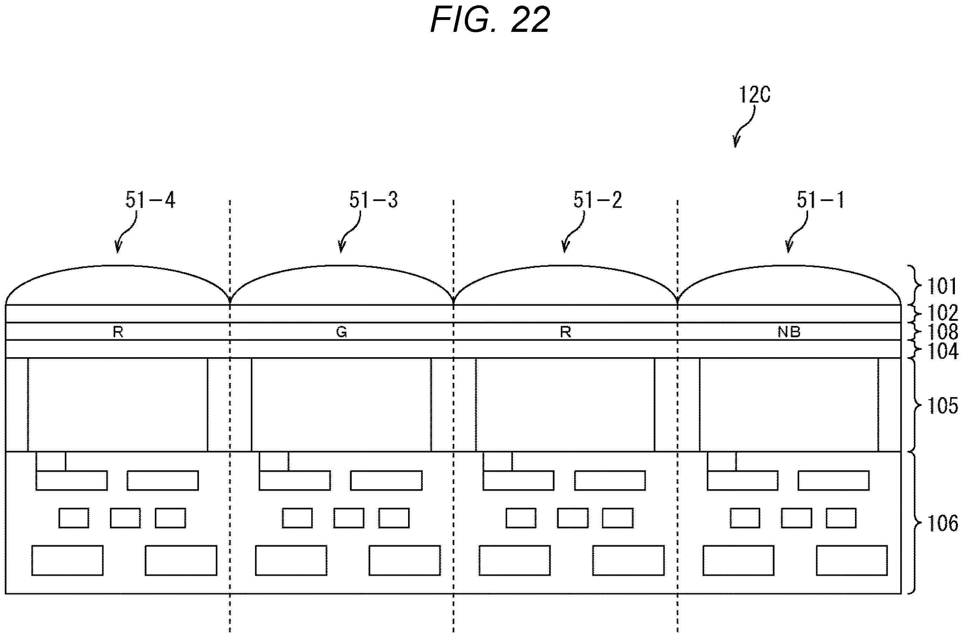

Next, with reference to Fig. 22, a third embodiment of the image pickup element 12 of Fig. 1 will be described.

Fig. 22 schematically illustrates a configuration example of a cross section of an image pickup element 12C, which is the third embodiment of the image pickup element 12. Here, in the drawing, parts corresponding to those of the image pickup element 12A in Fig. 3 are denoted by the same reference numerals, and the description thereof will be omitted as appropriate.

The image pickup element 12C is different from the image pickup element 12A in that a filter layer 108 is provided as a substitute for the narrow band filter layer 103. In addition, the image pickup element 12C is different from the image pickup element 12B in Fig. 16 in that a narrow band filter NB and color filters (for example, a red filter R, a green filter G, and a blue filter B) are provided in the same filter layer 108.

With this configuration, in a case where the R pixel, the G pixel, the B pixel, and the MS pixel are arranged in the pixel array 31 of the image pickup element 12C, the color filter layer 107 can be omitted.

Here, in a case where an organic material type color filter is used, for example, a narrow band filter NB is formed first and then color filter is formed after a high-temperature final heat treatment such as a sintering process is performed in order to prevent damage of the color filter due to heat and the like. On the other hand, in a case of using an inorganic material type color filter, basically, there is no need to restrict the above formation order.

Furthermore, in a case of taking measures against flare like the image pickup element 12B, as in the case of the image pickup element 12B in Fig. 16, a color filter layer may be laminated between the on-chip microlens 101 and the interlayer film 102. In this case, in the pixel 51 in which the narrow band filter NB is provided in the filter layer 108, the above-described transmission filter P is provided in the color filter layer. On the other hand, in the pixel 51 in which the color filter is provided in the filter layer 108, a filter is not provided in the color filter layer, or a dummy filter that transmits light of all wavelengths or a color filter in a same color as the filter layer 108 is provided.

<<2. Second embodiment>>

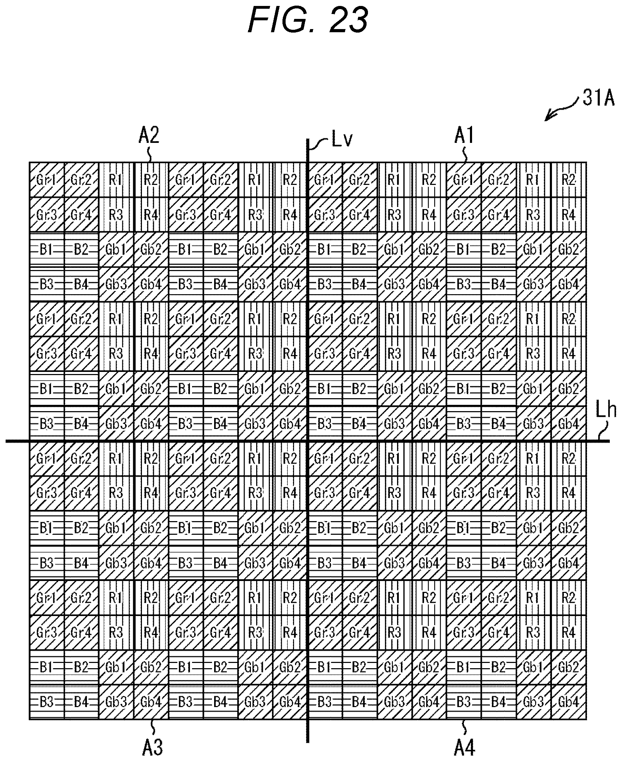

Next, a second embodiment of the present technology will be described with reference to Figs. 23 to 35.

<First embodiment of pixel array>

Fig. 23 illustrates an example of the pixel arrangement of a pixel array 31A which is a first embodiment of the pixel array 31 of Fig. 2. Note that the areas A1 to A4 are areas obtained by dividing the pixel array 31A into four areas of two rows and two columns by the vertical line Lv and the horizontal line Lh. Furthermore, the intersection of the vertical line Lv, the horizontal line Lh, and the horizontal line coincides with a center of the pixel array 31A.

In the pixel array 31A, the R pixel, the Gr pixel, the Gb pixel, and the B pixel are arranged in units of blocks of two rows and two columns, respectively (hereinafter referred to as pixel blocks). Furthermore, the arrangement of colors in units of pixel blocks is made according to the arrangement of the colors of the Bayer array. Here, in this case, the G pixel is divided into a Gr pixel arranged in the same row as the R pixel and a Gb pixel arranged in the same row as the B pixel.

Hereinafter, the arrangement of the pixels 51 is referred to as a Quadra array. Furthermore, in the following, a pixel block including R pixels (pixels R1 to R4) will be referred to as an R block. A pixel block including Gr pixels (pixels Gr1 to Gr4) is referred to as a Gr block. A pixel block including Gb pixels (pixels Gb1 to Gb4) is referred to as a Gb block. A pixel block including B pixels (pixels B1 to B4) is referred to as a B block.

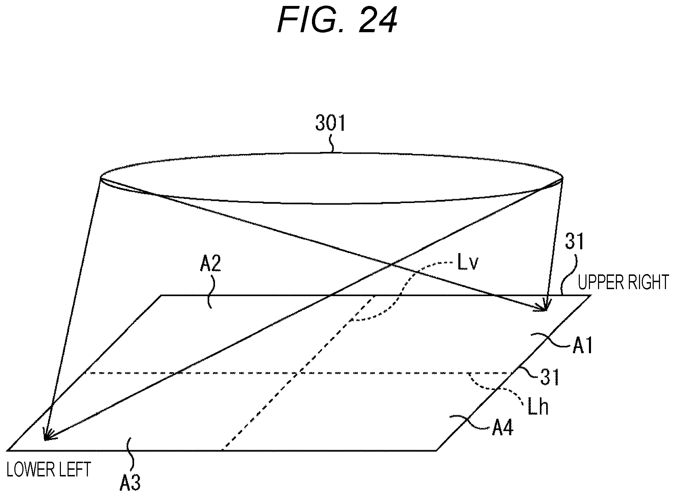

In the Quadra array, the sensitivities of the pixels 51 in the same pixel block are different. This will be described with reference to Figs. 24 to 26.

Fig. 24 schematically illustrates an angle of light entering the pixel array 31. In this example, the optical system 11 of Fig. 1 includes the lens 301, and a center of the pixel array 31 and an intersection point of the vertical line Lv and the horizontal line Lh coincide so that both are on an optical axis of the lens 301.

As illustrated in the diagram, light enters each pixel 51 of the pixel array 31 not only in a direction perpendicular to the pixel array 31 but also from an oblique direction. Furthermore, the incident direction of light varies depending on the position of the pixel 51. For example, regarding the pixel 51 in the upper right corner of the area A1, a large amount of light from the obliquely downward left direction enters. On the other hand, regarding the pixel 51 at the lower left corner of the area A3, a large amount of light from the obliquely upper right direction enters. Such light in an oblique direction (oblique light) becomes a cause of color mixing and causes a difference in sensitivity between the pixels 51 in the same pixel block.

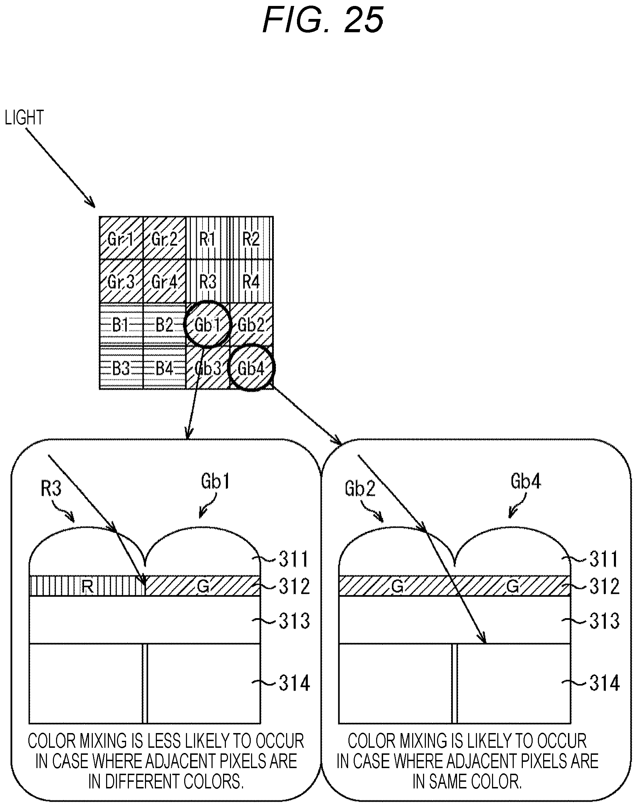

Fig. 25 illustrates a state of oblique light entering the pixel Gb1 and the pixel Gb4 in the area A4 of the pixel array 31.

The upper side of Fig. 25 illustrates an arrangement of colors of the pixels 51 in the area A4 of the pixel array 31.

A large amount of oblique light from the obliquely upward left direction is incident on the pixels 51 in the lower right corner, particularly in the area A4. At this time, in the pixel Gb1 surrounded by a circle in the drawing, not only the light directly entering the pixel Gb1 but also light from the upper pixel R3 and light from the right pixel B2 which are adjacent on the incident side of the oblique light are likely to enter. Here, since the contact area between the pixel Gr4 and the pixel Gb1 adjacent in the oblique direction on the incident side of the oblique light is very small, almost no light enters from the pixel Gr4 to the pixel Gb1.

In a similar manner, in the pixel Gb4 surrounded by a circle in the drawing, not only light directly entering the pixel Gb4 but also light from the upper pixel Gb3 and light from the right pixel Gb2 which are adjacent on the incident side of the oblique light are likely to enter. Here, since the contacting area between the pixel Gb1 and the pixel Gb4 adjacent in the oblique direction on the incident side of the oblique light is very small, almost no light enters from the pixel Gb1 to the pixel Gb4.

The lower left side of Fig. 25 schematically illustrates a cross section of a pixel Gb1 and a pixel R3 adjacent above the pixel Gb1. The lower right side of Fig. 25 schematically illustrates a cross section of a pixel Gb4 and a pixel Gb2 adjacent above the pixel Gb4.

On each pixel 51, an on-chip microlens 311, a filter layer 312, an interlayer film 313, and a photoelectric conversion element layer 314 are stacked in order from the top. Furthermore, in the pixels Gb1, Gb2, and Gb4, a green filter G is provided in the filter layer 312 and, in the pixel R3, a red filter R is provided in the filter layer 312.

Here, since the light passing through the on-chip microlens 311 of the pixel R3 and entering the boundary between the red filter R of the pixel R3 and the green filter G of the pixel Gb1 has different transmission bands of the red filter R and the green filter G, the light is blocked by the green filter G and hardly enters the pixel Gb1. In other words, in a case where the adjacent pixels 51 are in different colors, color mixing is less likely to occur.

On the other hand, light passing through the on-chip microlens 311 of the pixel Gb2 and entering the boundary between the green filter G of the pixel Gb2 and the green filter G of the pixel Gb4 mostly enters the pixel Gb4 without being blocked since both of the color filters are in the same transmission band. In other words, in a case where the adjacent pixels 51 are in a same color, color mixing is likely to occur.

Because of the difference in the ease of color mixture occurrence, a difference in sensitivity is generated between the pixels 51 in the same pixel block.

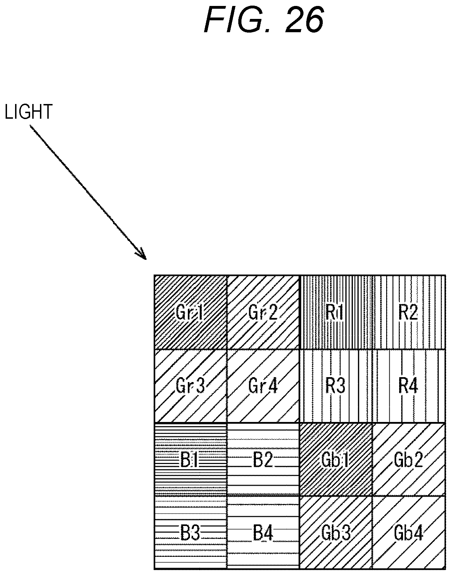

Specifically, as illustrated in Fig. 26, since the pixel Gb1 is adjacent to the pixel R3 and B2 in different colors on the incident side of the oblique light, color mixing is least likely to occur. Therefore, the sensitivity of the pixel Gb1 is the lowest and the pixel Gb1 becomes darker (has a smaller pixel value).

The pixel Gb2 is adjacent to the pixel Gb1 in the same color and the pixel R4 in a different color on the incident side of the oblique light. The pixel Gb3 is adjacent to the pixel Gb1 in the same color and the pixel B4 in a different color on the incident side of the oblique light. On the other hand, the red filter R has higher transmittance than the blue filter B in general. Therefore, the pixel Gb3 adjacent to the pixel B4 has lower sensitivity and is darker (has a smaller pixel value) than the pixel Gb2 adjacent to the pixel R4.

Since the pixel Gb4 is adjacent to the pixel Gb2 and the pixel Gb3 in the same color on the incident side of the oblique light, color mixing is most likely to occur. Therefore, the pixel Gb4 has the highest sensitivity and becomes brighter (has a larger pixel value).

Therefore, the sensitivity of each pixel 51 in the Gb block of the area A4 is basically in an order of pixel Gb4 > pixel Gb2 > pixel Gb3 > pixel Gb1. For a similar reason, the sensitivity of each pixel 51 in the Gr block of the area A4 is basically in an order of pixel Gr4 > pixel Gr3 > pixel Gr2 > pixel Gr1.

Basically, the sensitivity of each pixel 51 in the R block of the area A4 is in an order of pixel R4 > pixel R3 > pixel R2 > pixel R1. Note that the pixel R2 and the pixel R3 have the same color combination of the adjacent pixels 51 on the incident side of the oblique light, but their sensitivity slightly differs because of the difference between the pixel Gb4 adjacent to the pixel R2 and the pixel Gr4 adjacent to the pixel R3.

Basically, the sensitivity of each pixel 51 in the B block of the area A4 is in an order of pixel B4 > pixel B2 > pixel B3 > pixel B1. Note that the pixel B2 and the pixel B3 have the same color combination of the adjacent pixels 51 on the incidence side of the oblique light, but their sensitivity differs because of the difference between the pixel Gr4 adjacent to the pixel B2 and the pixel Gb4 adjacent to the pixel B3.

Although detailed description will be omitted, the sensitivity of each pixel 51 in the R block of the area A1 is basically in an order of pixel R2 > pixel R1 > pixel R4 > pixel R3. Basically, the sensitivity of each pixel 51 in the Gr block of the area A1 is in an order of pixel Gr2 > pixel Gr1 > pixel Gr4 > pixel Gr3. Basically, the sensitivity of each pixel 51 in the Gb block of the area A1 is in an order of pixel Gb2 > pixel Gb4 > pixel Gb1 > pixel Gb3. Basically, the sensitivity of each pixel 51 in the B block of the area A1 is in the order of pixel B2 > pixel B4 > pixel B1 > pixel B3.

Basically, the sensitivity of each pixel 51 in the R block of the area A2 is in an order of pixel R1 > pixel R2 > pixel R3 > pixel R4. Basically, the sensitivity of each pixel 51 in the Gr block of the area A2 is in an order of pixel Gr1 > pixel Gr2 > pixel Gr3 > pixel Gr4. Basically, the sensitivity of each pixel 51 in the Gb block of the area A2 is in an order of pixel Gb1 > pixel Gb3 > pixel Gb2 > pixel Gb4. Basically, the sensitivity of each pixel 51 in the B block of the area A2 is in an order of pixel B1 > pixel B3 > pixel B2 > pixel B4.

Basically, the sensitivity of each pixel 51 in the R block of the area A3 is in an order of pixel R3 > pixel R4 > pixel R1 > pixel R2. Basically, the sensitivity of each pixel 51 in the Gr block of the area A3 is in the order of pixel Gr3 > pixel Gr4 > pixel Gr1 > pixel Gr2. Basically, the sensitivity of each pixel 51 in the Gb block of the area A3 is in an order of pixel Gb3 > pixel Gb1 > pixel Gb4 > pixel Gb2. Basically, the sensitivity of each pixel 51 in the B block of the area A3 is an order of pixel B3 > pixel B1 > pixel B4 > pixel B2.

As described above, for each of the R pixel, the Gr pixel, the Gb pixel, and the B pixel, there are four types of pixels with different sensitivities in each pixel block. The difference in sensitivity between the pixels 51 in the same color may cause degradation of image quality or the like, for example.

Furthermore, even in a case of a pixel block in a same color, the distribution of the sensitivity of each pixel 51 is different from the area A1 to the area A4. For example, in the areas A1 to A4, the positions of the pixels 51 having the highest sensitivity in each pixel block are different.

<Second embodiment of pixel array>

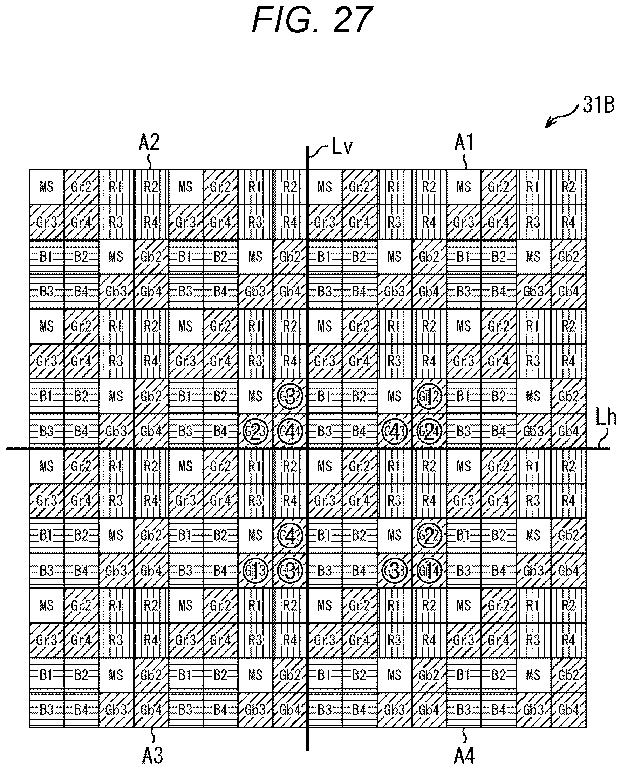

Fig. 27 illustrates an example of a pixel arrangement of a pixel array 31B which is a second embodiment of the pixel array 31 of Fig. 2.

In the pixel array 31B, multispectral pixels are arranged in addition to the R pixel, the G pixel, and the B pixel as in the above described image pickup element 12C in Fig. 22. Specifically, the pixel array 31B is different from the pixel placement of the pixel array 31 of Fig. 23 in that the pixel Gr1 of the Gr block and the pixel Gb1 of the Gb block are replaced with multispectral pixels MS. Note that the narrow band filter NB (not illustrated) provided in each multispectral pixel MS may have one transmission band or two or more transmission bands.

Here, the numbers in the circles in the drawing indicate sensitivity order of each pixel 51 in the Gb block in the pixel array 31A of the Quadra array before being replaced with the multispectral pixels MS. For example, the pixel 51 indicated by the number, 1, represents a pixel 51 having a highest sensitivity in the Gb block.

For example, in the Gb block of the area A1, the pixel Gb1 having a third highest sensitivity is replaced with a multispectral pixel MS. As a result, there remain the pixel Gb2 having a highest sensitivity, the pixel Gb4 having a second highest sensitivity, and the pixel Gb3 having a lowest sensitivity.

In the Gb block of the area A2, the pixel Gb1 having a highest sensitivity is replaced with a multispectral pixel MS. As a result, there remain the pixel Gb3 having a second highest sensitivity, the pixel Gb2 having a third highest sensitivity, and the pixel Gb4 having a lowest sensitivity.

In the Gb block of the area A3, the pixel Gb1 having a second highest sensitivity is replaced with a multispectral pixel MS. As a result, there remain the pixel Gb3 having a highest sensitivity, the pixel Gb4 having a third highest sensitivity, and the pixel Gb2 having a lowest sensitivity.

In the Gb block of the area A4, the pixel Gb1 having a lowest sensitivity is replaced with a multispectral pixel MS. As a result, there remain the pixel Gb4 having a highest sensitivity, the pixel Gb3 having a second highest sensitivity, and the pixel Gb2 having a third highest sensitivity.

As a result, in the pixel array 31B, the sensitivity of the Gb pixel remains unchanged from the four kinds as compared with the pixel array 31A in Fig. 23, and the variation in the sensitivity of the Gb pixel does not substantially change. Likewise, the sensitivity of the Gb pixel remains unchanged from the four kinds, and the variation in the sensitivity of the Gr pixel does not substantially change.

<Third embodiment of pixel array>

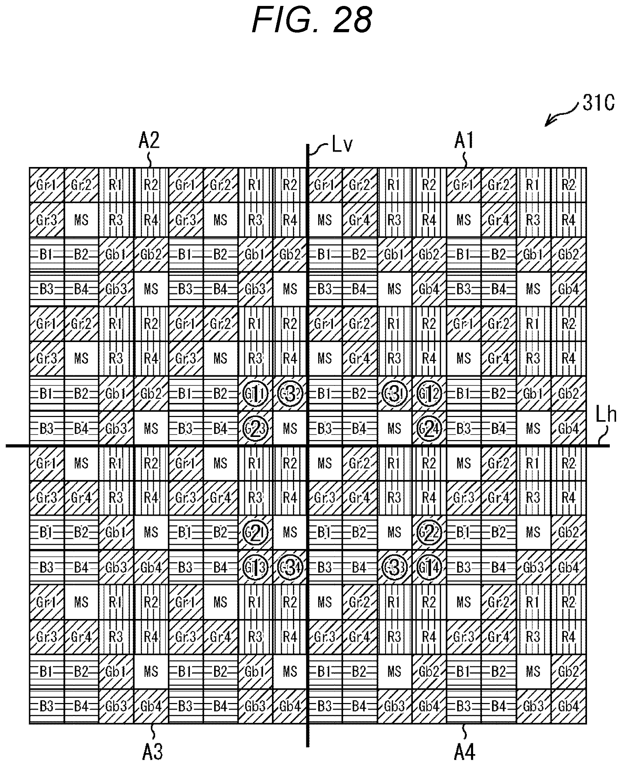

Fig. 28 illustrates an example of a pixel arrangement of a pixel array 31C which is a third embodiment of the pixel array 31 of Fig. 2.

As in the pixel array 31B in Fig. 27, in the pixel array 31C, a single multispectral pixel MS is arranged in each of the Gr block and the Gb block respectively.

On the other hand, in the pixel array 31C, unlike the pixel array 31B, the positions of the multispectral pixels MS in the pixel block are different in the areas A1 to A4. More specifically, in the pixel array 31C, the pixel 51 having a lowest sensitivity in the Gr block of the pixel array 31A in Fig. 23 and the pixel 51 having a lowest sensitivity in the Gb block are replaced with multispectral pixels MS.

For example, in the area A1, the pixels Gr3 and Gb3 are replaced with multispectral pixels MS. In the area A2, the pixels Gr4 and Gb4 are replaced with multispectral pixels MS. In the area A3, the pixels Gr2 and Gb2 are replaced with multispectral pixels MS. In the area A4, the pixels Gr1 and Gb1 are replaced with multispectral pixel MS.

As a result, the position of the multispectral pixel MS in the Gr block in each of the areas A1 to A4 is symmetrical with respect to a center (the optical axis of the lens 301) of the pixel array 31C. In a similar manner, the position of the multispectral pixel MS in the Gb block in each of the areas A1 to A4 is symmetrical with respect to the center (the optical axis of the lens 301) of the pixel array 31C.

In addition, the combination of colors of adjacent pixels 51 on the incidence side of the oblique light of each multispectral pixel MS coincides as being red (R) and blue (B). In other words, among the multispectral pixels MS, the color combination of the pixel 51 which is closer to the optical axis of the lens 301 (the center of the pixel array 31C) among the adjacent upper and lower pixels 51, and the pixel 51 which is closer to the optical axis of the lens 301 (the center of the pixel array 31C) among the adjacent left and right pixels 51 coincides as being red (R) and blue (B).

For example, in the area A1, the pixel R1 and the pixel B4, or the pixel B1 and the pixel R4 are adjacent to the lower side and the left side closer to the optical axis of the lens 301 of the multispectral pixel MS. In the area A2, the pixel R2 and the pixel B3, or the pixel B2 and the pixel R3 are adjacent to the lower side and the right side closer to the optical axis of the lens 301 of the multispectral pixel MS. In the area A3, the pixel R4 and the pixel B1, or the pixel B4 and the pixel R1 are adjacent to the upper side and the right side closer to the optical axis of the lens 301 of the multispectral pixel MS. In the area A4, the pixel R3 and the pixel B2, or the pixel B3 and the pixel R2 are adjacent to the upper side and the left side closer to the optical axis of the lens 301 of the multispectral pixel MS.

As a result, in the pixel array 31C, as compared with the pixel array 31A in Fig. 23 and the pixel array 31B in Fig. 27, the sensitivity of the Gr pixel is reduced to three kinds, and the sensitivity difference of the Gr pixel is suppressed. In a similar manner, the sensitivity of the Gb pixel is reduced to three types, and the sensitivity difference of the Gb pixel is suppressed.

<Fourth embodiment of pixel array>

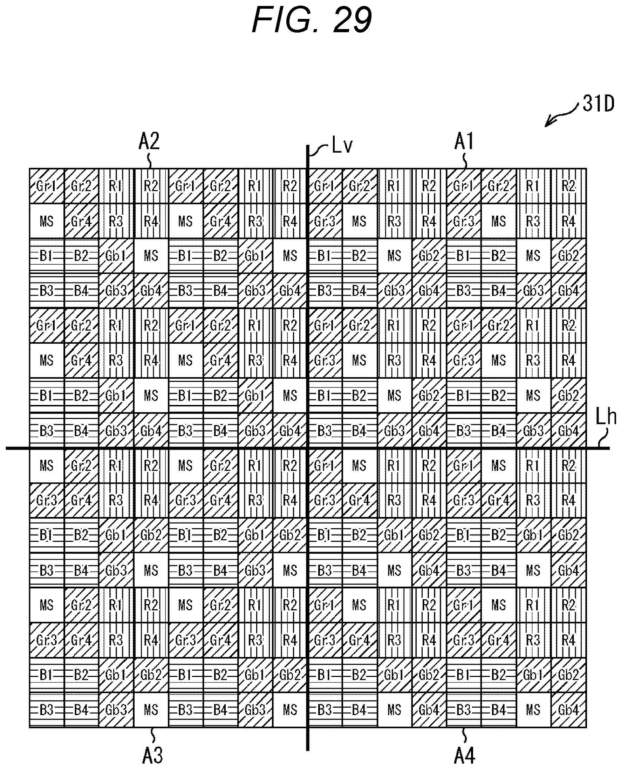

Fig. 29 illustrates an example of a pixel arrangement of a pixel array 31D which is a fourth embodiment of the pixel array 31 of Fig. 2.

As in the pixel array 31B of Fig. 27, in the pixel array 31D, a single multispectral pixel MS is arranged in each of the Gr block and the Gb block.

On the other hand, the position of the multispectral pixel MS of the pixel array 31D is different from that of the pixel array 31B. More specifically, in the pixel array 31D, the pixel 51 having a second lowest sensitivity in the Gr block of the pixel array 31A in Fig. 23 and the pixel 51 having a second lowest sensitivity in the Gb block are replaced with the multispectral pixel MS.

More specifically, in the area A1, the pixels Gr4 and Gb1 are replaced with the multispectral pixels MS. In the area A2, the pixels Gr3 and Gb2 are replaced with multispectral pixels MS. In the area A3, the pixels Gr1 and Gb4 are replaced with multispectral pixels MS. In the area A4, the pixels Gr2 and Gb3 are replaced with multispectral pixels MS.

With this configuration, the position of the multispectral pixel MS in the Gr block in each of the areas A1 to A4 is symmetrical with respect to the center (the optical axis of the lens 301) of the pixel array 31D. In a similar manner, the position of the multispectral pixel MS in the Gb block in each of the areas A1 to A4 is symmetrical with respect to the center (the optical axis of the lens 301) of the pixel array 31D.

Furthermore, the combination of colors of adjacent pixels on the incidence side of the oblique light of each multispectral pixel MS coincides as being green (Gb or Gr) and blue (B). In other words, among the multispectral pixels MS, the color combination of the pixel 51 which is closer to the optical axis of the lens 301 (the center of the pixel array 31D) among the adjacent upper and lower pixels 51, and the pixel 51 which is closer to the optical axis of the lens 301 (the center of the pixel array 31D) among the adjacent left and right pixels 51 coincides as being green (Gb or Gr) and blue (B).

As a result, in the pixel array 31D, the sensitivity of the Gr pixel is reduced to three kinds as compared with the pixel array 31A of Fig. 23 and the pixel array 31B of Fig. 27, and the sensitivity difference of the Gr pixel is suppressed. In a similar manner, the sensitivity of the Gb pixel is reduced to three types, and the sensitivity difference of the Gb pixel is suppressed.

<Fifth embodiment of pixel array>

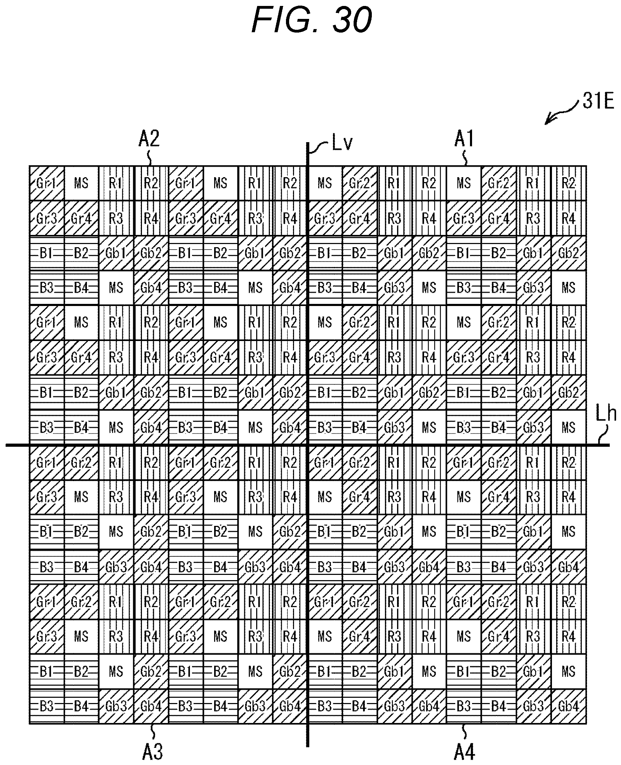

Fig. 30 illustrates an example of a pixel arrangement of a pixel array 31E which is a fifth embodiment of the pixel array 31 of Fig. 2.

As in the pixel array 31B of Fig. 27, in the pixel array 31E, a single multispectral pixel MS is arranged in each of the Gr block and the Gb block.

On the other hand, in the pixel array 31E, the position of the multispectral pixel MS is different from that of the pixel array 31B. More specifically, in the pixel array 31E, the pixel 51 having a second highest sensitivity in the Gr block of the pixel array 31A of Fig. 23 and the pixel 51 with a second highest sensitivity in the Gb block are replaced with the multispectral pixel MS.

In more detail, in the area A1, the pixels Gr1 and Gb4 are replaced with multispectral pixels MS. In the area A2, the pixels Gr2 and Gb3 are replaced with multispectral pixels MS. In the area A3, the pixels Gr4 and Gb1 are replaced with multispectral pixel MS. In the area A4, the pixels Gr3 and Gb2 are replaced with multispectral pixels MS.

As a result, the position of the multispectral pixel MS in the Gr block in each of the areas A1 to A4 is symmetrical with respect to a center (the optical axis of the lens 301) of the pixel array 31E. In a similar manner, the position of the multispectral pixel MS in the Gb block in each of the areas A1 to A4 is symmetrical with respect to the center (the optical axis of the lens 301) of the pixel array 31E.

Furthermore, the color combination of adjacent pixels on the incidence side of the oblique light of each multispectral pixel MS coincides as being green (Gb or Gr) and red (R). In other words, among the multispectral pixels MS, the color combination of the pixel 51 which is closer to the optical axis of the lens 301 (the center of the pixel array 31E) among the adjacent upper and lower pixels 51, and the pixel 51 which is closer to the optical axis of the lens 301 (the center of the pixel array 31E) among the adjacent left and right pixels 51 coincides as being green (Gb or Gr) and red (R).

As a result, in the pixel array 31E, as compared with the pixel array 31A in Fig. 23 and the pixel array 31B in Fig. 27, the sensitivity of the Gr pixel is reduced to three kinds, and the sensitivity difference of the Gr pixel is suppressed. In a similar manner, the sensitivity of the Gb pixel is reduced to three types, and the sensitivity difference of the Gb pixel is suppressed.

<Sixth embodiment of pixel array>

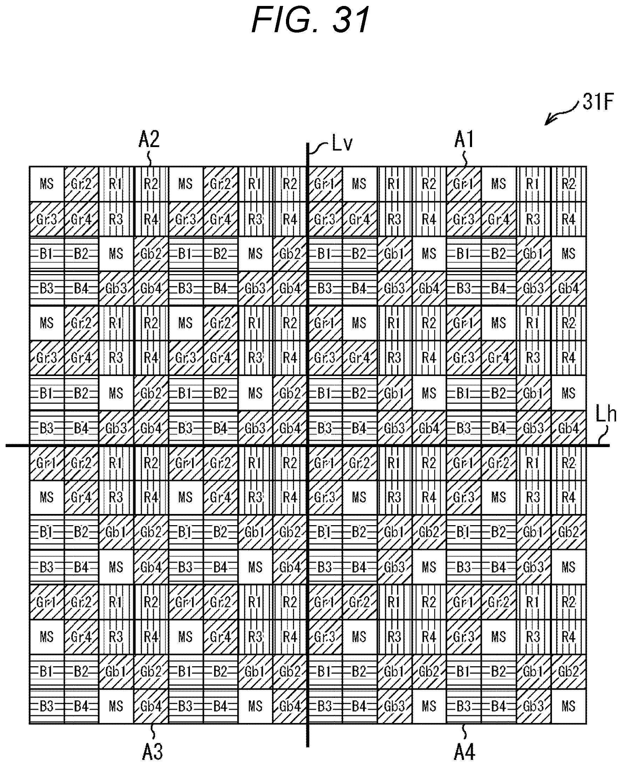

Fig. 31 illustrates an example of a pixel arrangement of a pixel array 31F which is a sixth embodiment of the pixel array 31 of Fig. 2.

As in the pixel array 31B in Fig. 27, in the pixel array 31F, a single multispectral pixel MS is arranged in each of the Gr block and Gb block.

On the other hand, in the pixel array 31F, the position of the multispectral pixel MS is different from that of the pixel array 31B. More specifically, in the pixel array 31F, the pixel 51 having a highest sensitivity in the Gr block of the pixel array 31A in Fig. 23 and the pixel 51 having a highest sensitivity in the Gb block are replaced with multispectral pixels MS.

In more detail, in the area A1, the pixels Gr2 and Gb2 are replaced with multispectral pixels MS. In the area A2, the pixels Gr1 and Gb1 are replaced with multispectral pixel MS. In the area A3, the pixels Gr3 and Gb3 are replaced with multispectral pixels MS. In the area A4, the pixels Gr4 and Gb4 are replaced with multispectral pixels MS.

As a result, the position of the multispectral pixel MS in the Gr block in each of the areas A1 to A4 is symmetrical with respect to the center (the optical axis of the lens 301) of the pixel array 31F. In a similar manner, the position of the multispectral pixel MS in the Gb block in each of the areas A1 to A4 is symmetrical with respect to the center (the optical axis of the lens 301) of the pixel array 31F.

Furthermore, the color combination of adjacent pixels on the incidence side of the oblique light of each multispectral pixel MS coincides as being green (Gb or Gr). In other words, among the multispectral pixels MS, the combination of colors of the pixel 51 which is closer to the optical axis of the lens 301 (the center of the pixel array 31F) among the adjacent upper and lower pixels 51, and the pixel 51 which is closer to the optical axis of the lens 301 (the center of the pixel array 31F) among the adjacent left and right pixels 51 coincides as being green (Gb or Gr).

As a result, in the pixel array 31F, as compared with the pixel array 31A in Fig. 23 and the pixel array 31B in Fig. 27, the sensitivity of Gr pixels is reduced to three kinds, and the sensitivity difference of Gr pixels is suppressed. In a similar manner, the sensitivity of the Gb pixel is reduced to three types, and the sensitivity difference of the Gb pixel is suppressed.

<Seventh embodiment of pixel array>

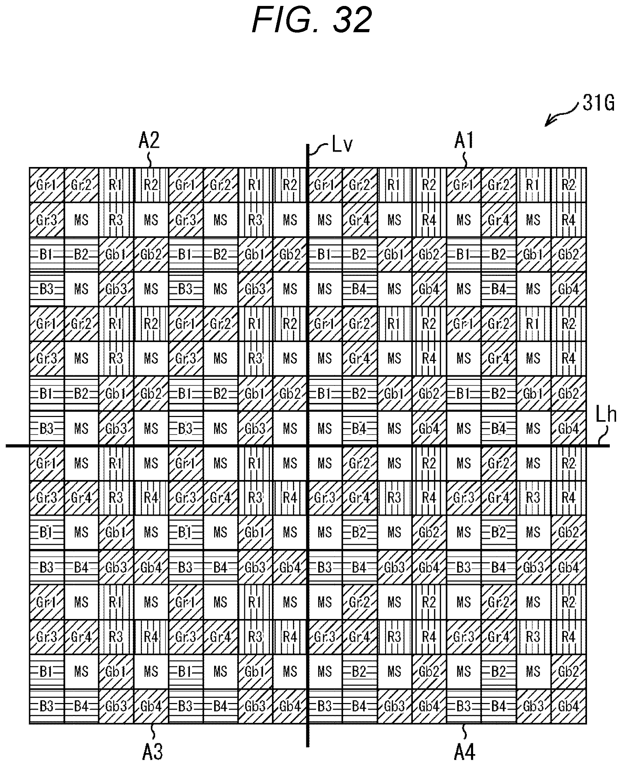

Fig. 32 illustrates an example of a pixel arrangement of a pixel array 31G which is a seventh embodiment of the pixel array 31 of Fig. 2.

In the pixel array 31G, a single multispectral pixel MS is arranged in each pixel block. More specifically, in the pixel array 31G, the pixel 51 having a lowest sensitivity of each pixel block of the pixel array 31A in Fig. 23 is replaced with a multispectral pixel MS.

In more detail, in the area A1, the pixel R3, the pixel Gr3, the pixel Gb3, and the pixel B3 are replaced with multispectral pixels MS. In the area A2, the pixel R4, the pixel Gr4, the pixel Gb4, and the pixel B4 are replaced with multispectral pixels MS. In the area A3, the pixel R2, the pixel Gr2, the pixel Gb2, and the pixel B2 are replaced with multispectral pixels MS. In the area A4, the pixel R1, the pixel Gr1, the pixel Gb1, and the pixel B1 are replaced with multispectral pixels MS.

As a result, the position of the multispectral pixel MS in the R block in each of the areas A1 to A4 is symmetrical with respect to the center (the optical axis of the lens 301) of the pixel array 31G. The position of the multispectral pixel MS in the Gr block in each of the areas A1 to A4 is symmetrical with respect to the center of the pixel array 31G (the optical axis of the lens 301). The position of the multispectral pixel MS in the Gb block in each of the areas A1 to A4 is symmetrical with respect to the center (the optical axis of the lens 301) of the pixel array 31G. The position of the multispectral pixel MS in the B block in each of the areas A1 to A4 is symmetrical with respect to the center (the optical axis of the lens 301) of the pixel array 31G.

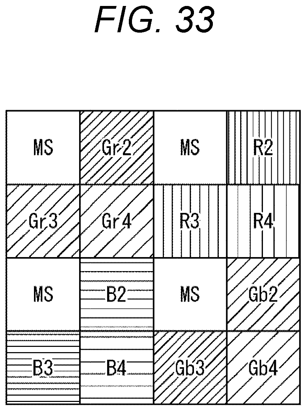

As a result, as illustrated in Fig. 33, in the pixel array 31G, as compared with the pixel array 31A of Fig. 23 and the pixel array 31B of Fig. 27, the sensitivity of the R pixel is reduced to three kinds, and the sensitivity difference of the R pixel is suppressed. The sensitivity of the Gr pixel is reduced to three kinds, and the sensitivity difference of the Gr pixel is suppressed. The sensitivity of the Gb pixel is reduced to three kinds, and the sensitivity difference of the Gb pixel is suppressed. The sensitivity of the B pixel is reduced to three kinds, and the sensitivity difference of the B pixel is suppressed.

<Eighth embodiment of pixel array>

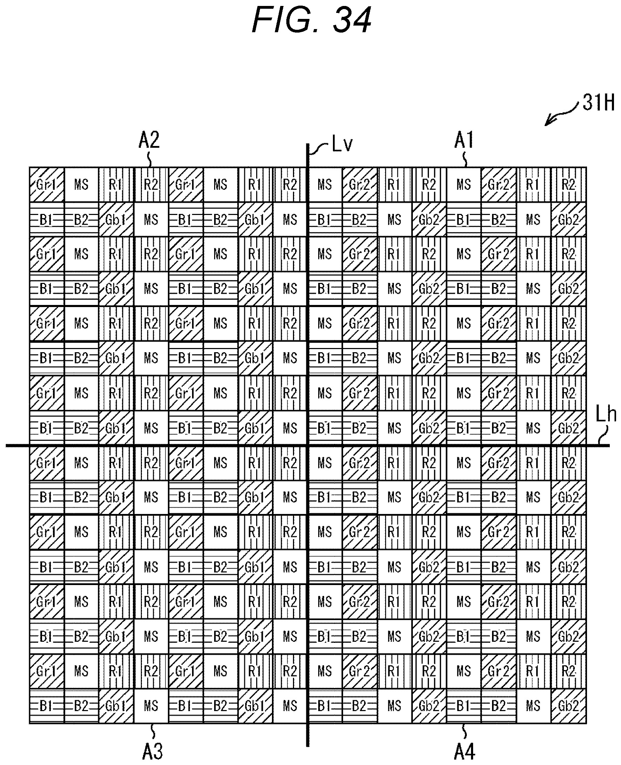

Fig. 34 illustrates an example of the pixel arrangement of a pixel array 31H which is an eighth embodiment of the pixel array 31 of Fig. 2.

In the pixel array 31H, R pixels, Gr pixels, Gb pixels, and B pixels are arranged in blocks in one row and two columns respectively, and the color arrangement in units of pixel blocks is in accordance with the color arrangement of the Bayer array.

However, in each Gr block, one pixel 51 is replaced with a multispectral pixel MS. More specifically, in the area A1 and the area A4, the pixel Gr1 on the left side in the Gr block is replaced with a multispectral pixel MS. In the area A2 and the area A3, the pixel Gr2 on the right side in the Gr block is replaced with a multispectral pixel MS.

In a similar manner, one pixel 51 in each Gb block is replaced with a multispectral pixel MS. More specifically, in the area A1 and the area A4, the pixel Gb1 on the left side in the Gb block is replaced with the multispectral pixel MS. In the areas A2 and A3, the right pixel Gb2 in the Gb block is replaced with the multispectral pixel MS.

With this configuration, the position of the multispectral pixel MS in the Gr block in each of the areas A1 to A4 is symmetrical with respect to a center (the optical axis of the lens 301) of the pixel array 31H. Furthermore, the position of the multispectral pixel MS in the Gr block in each of the areas A1 to A4 is symmetrical with respect to the vertical line Lv.

In a similar manner, the position of the multispectral pixel MS in the Gb block in each of the areas A1 to A4 is symmetrical with respect to the center (the optical axis of the lens 301) of the pixel array 31H. Furthermore, the position of the multispectral pixel MS in the Gb block in each of the areas A1 to A4 is symmetrical with respect to the vertical line Lv.

As a result, in the pixel array 31H, the sensitivity difference of the Gr pixel and the sensitivity difference of the Gb pixel are suppressed.

<Ninth embodiment of pixel array>

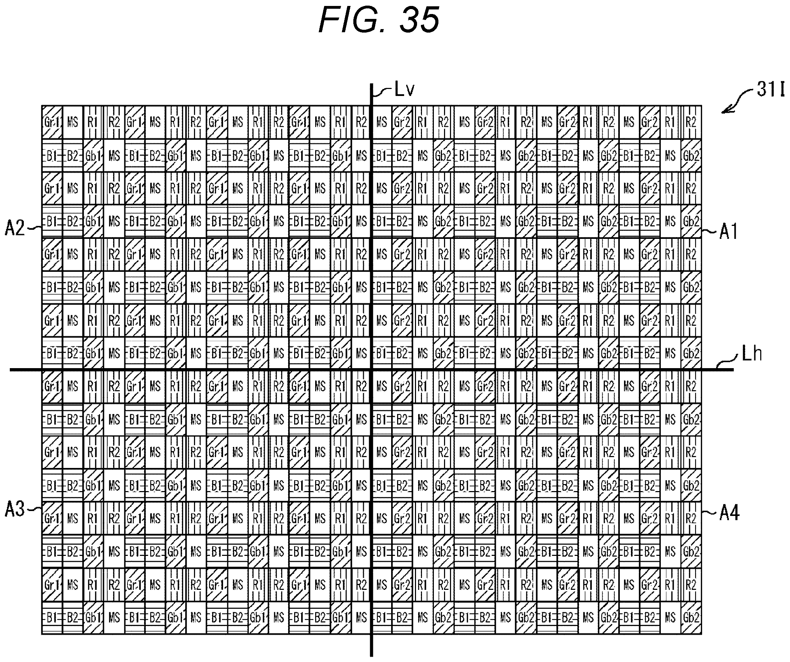

Fig. 35 illustrates an example of a pixel arrangement of a pixel array 31I which is a ninth embodiment of the pixel array 31 of Fig. 2.

A color arrangement of the pixel array 31 is basically made according to Bayer array. However, in each pixel 51, two photodiodes (not illustrated) are arranged so as to be aligned in a horizontal direction so that two light receiving areas are arranged in the horizontal direction. With this configuration, a block (hereinafter, referred to as a light receiving area block) including light receiving areas in one row and two columns is formed in each pixel 51 (divided pixel). Then, for example, detection of a phase difference or the like is performed on the basis of a difference between the light receiving amounts of the two light receiving areas in the same pixel 51.

Note that the light receiving areas indicated by R1 and R2 in the drawing receive red light, the light receiving areas indicated by Gr1, Gr2, Gb1, and Gb2 receive green light, and the light receiving areas indicated by B1 and B2 receive blue light.

Therefore, light receiving areas of the same color are arranged in each of the R pixel and the B pixel. On the other hand, in the Gr pixel and the Gb pixel, a multispectral light receiving area MS for receiving narrow band light is arranged in one of the right and left side.

Moe specifically, within the areas A1 and A4, the multispectral light receiving area MS is arranged in the Gr pixel and on the left side in the Gb pixel. In the areas A2 and A3, the multispectral light receiving area MS is arranged in the Gr pixel and on the right side within the Gb pixel.

As a result, the position of the multispectral pixel MS within the Gr pixel (within the light receiving area block) in each of the areas A1 to A4 is symmetrical with respect to the center of the pixel array 31I. Furthermore, the position of the multispectral pixel MS within the Gr pixel (within the light receiving area block) in each of the areas A1 to A4 is symmetrical with respect to the vertical line Lv.

In a similar manner, the position of the multispectral pixel MS within the Gb pixel (within the light receiving area

17

block) in each area of the areas A1 to A4 is symmetrical with respect to the center of the pixel array 31I. Furthermore, the position of the multispectral pixel MS within the Gb pixel (in the light receiving area block) in each area of the areas A1 to A4 is symmetrical with respect to the vertical line Lv.

As a result, in the pixel array 31I, the sensitivity difference of the light receiving area Gr and the sensitivity difference of the light receiving area Gb are suppressed.

Here, the second embodiment can be applied to any of cases that the color filter layer 107 and the narrow band filter layer 103 are laminated as in the image pickup element 12B of Fig. 16 and that a color filter and a narrow band filter are provided in the filter layer 108 as in the image pickup element 12C of Fig. 22.

## <<3. Modification examples>>

In the following, a modified example of the above described embodiment of the present technology will be described.

The example of the pixel arrangement of the pixel array 31, which has been described above with reference to Figs. 28 to 35, is one example thereof, and other pixel arrangements can be adopted. In a case where another pixel arrangement is employed, for example, light receiving units (multispectral pixels or multispectral light receiving areas; hereinafter, referred to as multispectral light receiving units) for receiving narrow band light in a light receiving unit (a pixel of a light receiving area) in a block (a pixel block or a light receiving area block) that receives light of a predetermined color (for example, R, Gr, Gb, or B) are arranged so that positions of the multispectral light receiving units are symmetrical with respect to the center of the pixel array 31 (the optical axis of the optical system 11). A similar configuration can be employed in a case where a number of multispectral light receiving units in the block is two or more.

Here, as in the pixel array 31H of Fig. 34 and the pixel array 31I of Fig. 35, in a case where a number of rows of blocks, which receives a predetermined color, is one row, the multispectral light receiving units may be arranged so that the positions of the multispectral light receiving units are symmetrical with respect to the vertical line Lv. Furthermore, in the case where the number of rows of blocks receiving a predetermined color is one row, the multispectral light receiving units may be arranged so that the positions of the multispectral light receiving units in the block are symmetrical with respect to the horizontal line Lh.

Furthermore, the intersection of the vertical line Lv and horizontal line Lh dividing the pixel array 31 does not necessarily coincide with the center of the pixel array 31. For example, in a case where the optical axis of the optical system 11 does not coincide with the center of the pixel array 31, the intersection of the vertical line Lv and the horizontal line Lh coincides with the optical axis of the optical system 11 and does not coincide with the center of the pixel array 31. In this case, for example, the multispectral light receiving units are arranged so that the positions of the multispectral light receiving units in the block are symmetrical with respect to the intersection point (the optical axis of the optical system 11) of the vertical line Lv and the horizontal line Lh.

Furthermore, the present technology can be applied not only to the above described back-illuminated CMOS image sensor but also to another image pickup element using a plasmon filter. For example, the present technology can be applied to a front-illuminated CMOS image sensor, a charge coupled device (CCD) image sensor, an image sensor having a photoconductor structure including an organic photoelectric conversion film, a quantum dot structure, and the like, for example.

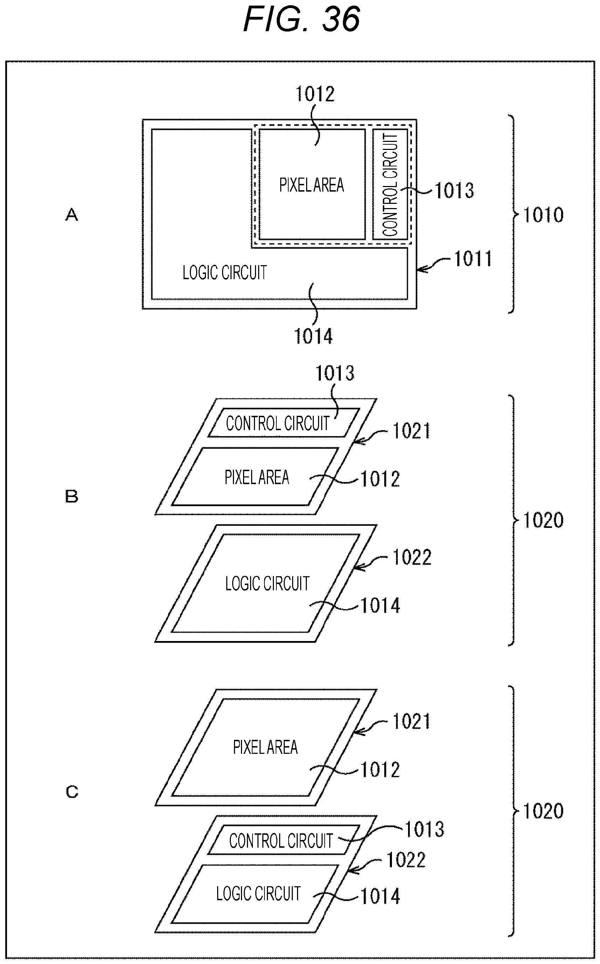

Furthermore, the present technology can be applied to, for example, a laminated solid-state image pickup apparatus illustrated in Fig. 36.

A of Fig. 36 illustrates a schematic configuration example of a non-stacked solid-state image pickup apparatus. A solid-state image pickup apparatus 1010 has one die (semiconductor substrate) 1011, as illustrated in A of Fig. 36. On the die 1011, there are mounted a pixel area 1012 in which pixels are arranged in an array, a control circuit 1013 for driving various pixels and other various controls, and a logic circuit 1014 for signal processing.

B of Fig. 36 and C of Fig. 36 illustrate schematic configuration examples of the laminated solid-state image pickup apparatus. In the solid-state image pickup apparatus 1020, as illustrated in B of Fig. 36 and C of Fig. 36, two dies of a sensor die 1021 and a logic die 1022 are laminated and electrically connected to each other to constitute a single semiconductor chip.

In B of Fig. 36, a pixel area 1012 and a control circuit 1013 are mounted on the sensor die 1021, and a logic circuit 1014 including a signal processing circuit for performing signal processing is mounted on the logic die 1022.

In C of Fig. 36, a pixel area 1012 is mounted on a sensor die 1021, and a control circuit 1013 and a logic circuit 1014 are mounted on the logic die 1024.

Furthermore, the present technology can also be applied to an image pickup element using a narrow band filter such as a metal thin film filter other than a plasmon filter. Furthermore, as such a narrow band filter, there may be an optical filter to which a photonic crystal using a semiconductor material is applied, a Fabry-Perot interference filter, or the like.

<<4. Application examples>>

Next, application examples of the present technology will be described.

<Application example of the present technology>

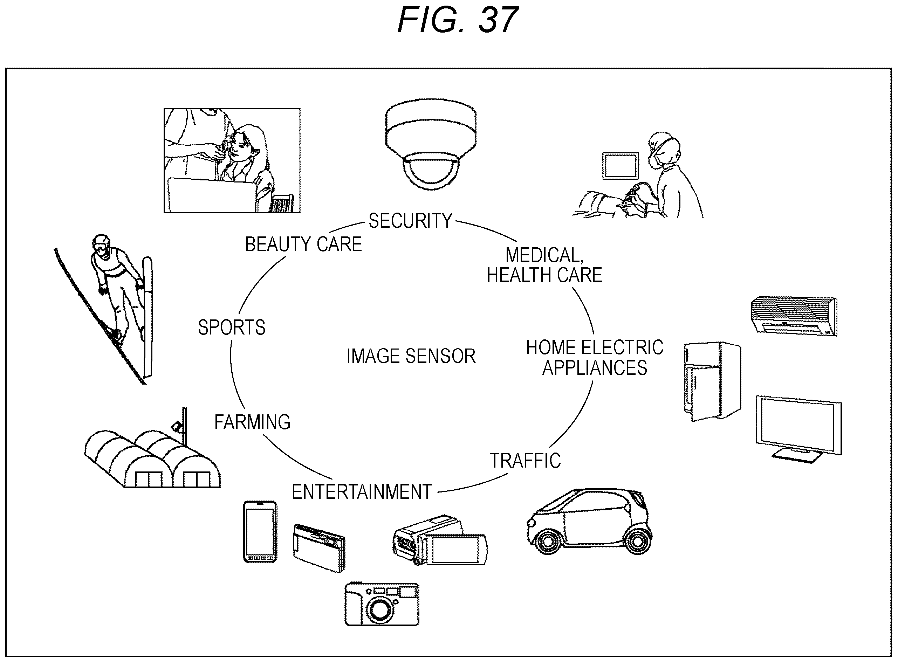

For example, as illustrated in Fig. 37, the present technology can be applied to various cases of sensing light such as visible light, infrared light, ultraviolet light, X-rays, and the like.

- A device used to capture an image to be viewed, such as a digital camera, a cell phone including a camera function, or the like
- A device used for traffic, such as a vehicle-mounted sensor for capturing an image in front and back of a vehicle, surroundings, vehicle interior or the like, a monitoring camera for monitoring traveling vehicles or streets, a distance measurement sensor for measuring a distance between vehicles, or the like in purpose of safe driving such as automatic stopping, recognition of driver's condition, and the like
- A device provided in home electric appliances such as a TV, a refrigerator, an air conditioner, and the like, to capture an image of user's gesture and perform a device operation according to the gesture
- A device used in medical or health care, such as an endoscope, an electron microscope, an angiography device using a reception of infrared light
- A device for security, such as a monitoring camera for crime prevention, a camera for person identification, or the like
- A device for beauty care, such as a skin measurement device for capture an image of a skin, a microscope for capturing an image of a scalp, or the like
- A device for sports, such as an action camera, a wearable camera, or the like used for sports
- A device for farming, such as a camera for monitoring a condition of a field or farm products

A more specific application example will be described below.

For example, by adjusting the transmission band of the narrow band filter NB of each pixel 51 of the image pickup apparatus 10 of Fig. 1, the wavelength band (hereinafter, referred to as a detection band) of the light detected by each pixel 51 of the image pickup apparatus 10 can be adjusted. Then, by appropriately setting the detection band of each pixel 51, the image pickup apparatus 10 can be used for various purposes.

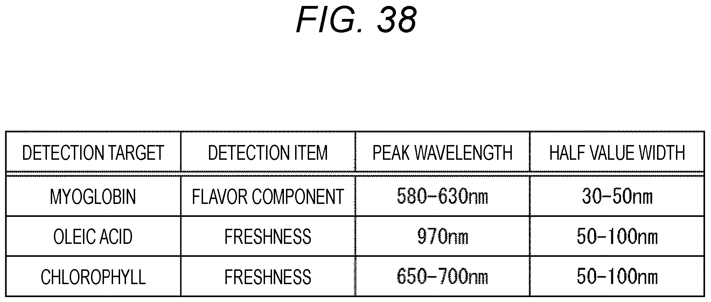

For example, Fig. 38 illustrates an example of a detection band in a case of detecting a flavor or freshness of food.

For example, in a case of detecting myoglobin, which indicates a flavor component of tuna, beef, and the like, a peak wavelength of the detection band is in a range of 580 to 630 nm and a half value width is in a range of 30 to 50 nm. In a case of detecting oleic acid, which indicates freshness of tuna, beef, and the like, the peak wavelength of the detection band is 980 nm and the half value width is in a range of 50 to 100 nm. In a case of detecting chlorophyll, which indicates freshness of leafy vegetables such as Japanese mustard spinach, the peak wavelength of the detection band is in a range of 650 to 700 nm and the half value width is in a range of 50 to 100 nm.

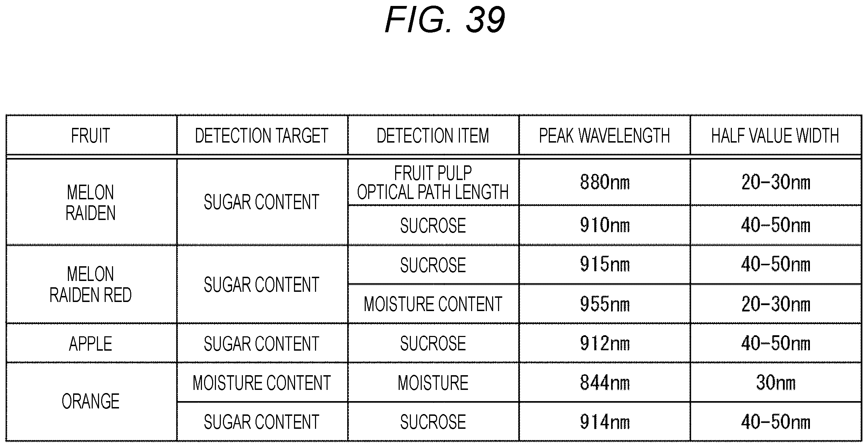

Fig. 39 illustrates an example of a detection band in the case of detecting a sugar content and a moisture content of fruits.

For example, in a case of detecting a fruit optical path length, which indicates a sugar content of Raiden, a kind of melon, the peak wavelength of the detection band is 880 nm and the half value width is in a range of 20 to 30 nm. In a case of detecting sucrose, which indicates a sugar content of the starch, the peak wavelength of the detection band is 910 nm and the full width at half maximum is in a range of 40 to 50 nm. In a case of detecting sucrose, which indicates a sugar content of Raiden Red, another kind of melon, the peak wavelength of the detection band is 915 nm and the half value width is in a range of 40 to 50 nm. In a case of detecting a moisture content, which indicates the sugar content of Raiden Red, the peak wavelength of the detection band is 955 nm and the half value width is in a range of 20 to 30 nm.

In a case of detecting sucrose, which indicates a sugar content of a sugar content of an apple, the peak wavelength of the detection band is 912 nm, and the half value width is in a range of 40 to 50 nm. In a case of detecting moisture, which indicates a moisture content of an orange, the peak wavelength of the detection band is 844 nm, and the half value width is 30 nm. In a case of detecting sucrose, which indicates a sugar content of the orange, the peak wavelength of the detection band is 914 nm and the half value width is in a range of 40 to 50 nm.

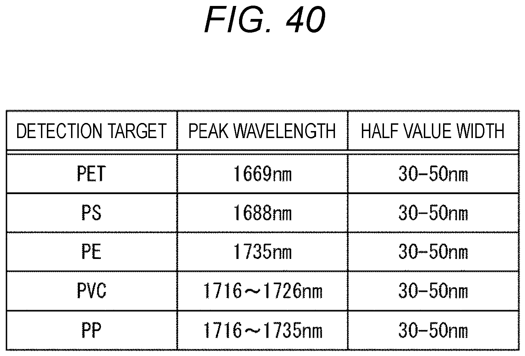

Fig. 40 illustrates an example of the detection band in a case of sorting plastics.

For example, in a case of detecting poly ethylene terephthalate (PET), the peak wavelength of the detection band is 1669 nm, and the half value width is in a range of 30 to 50 nm. In a case of detecting poly styrene (PS), the peak wavelength of the detection band is 1688 nm, and the half value width is in a range of 30 to 50 nm. In a case of detecting poly ethylene (PE), the peak wavelength of the detection band is 1735 nm, and the half value width is in a range of 30 to 50 nm. In a case of detecting poly vinyl cloride (PVC), the peak wavelength of the detection band is in a range of 1716 to 1726 nm, and the half value width is in a range of 30 to 50 nm. In a case of detecting Polyepropylene (PP), the peak wavelength of the detection band is in a range of 1716 to 1735 nm and the half value width is in a range of 30 to 50 nm.

Furthermore, for example, the present technology can be applied to freshness management of cut flowers.

Furthermore, for example, the present technology can be applied to inspection of a foreign substance mixed in food. For example, the present technology can be applied to detection of a foreign substance such as skin, shell, stone, leaves, branches, wood chips, and the like mixed in nuts or fruits such as almonds, blueberries, walnuts, and the like. Furthermore, for example, the present technology can be applied to detection of a foreign substance such as a plastic piece mixed in processed food, beverage, and the like.

Furthermore, for example, the present technology can be applied to detection of a normalized difference vegetation index (NDVI), which is an indicator of vegetation.

Furthermore, for example, the present technology can be applied to human detection on the basis of one of or both of a spectroscopic shape near the wavelength of 580 nm derived from human hemoglobin and a spectroscopic shape near the wavelength of 960 nm derived from melanin pigment contained in the human skin.

Furthermore, for example, the present technology can be applied to forgery prevention, monitoring, and the like of organism detection (biometric authentication), user interface, signature, and the like.

<Example of application to endoscopic surgery system>

Furthermore, for example, the technology (the present technology) according to the present disclosure may be applied to an endoscopic surgical system.

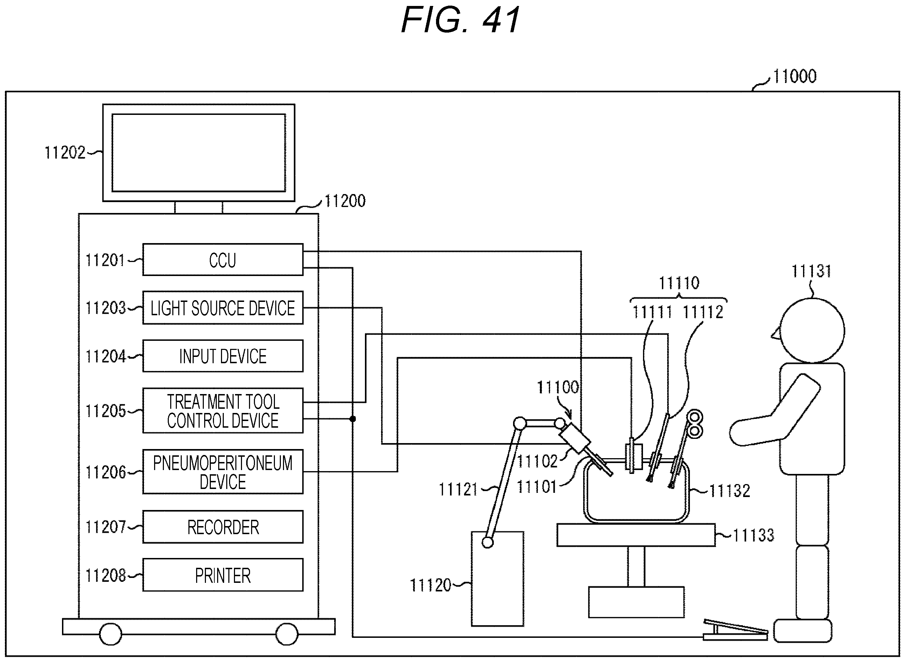

Fig. 41 is a diagram illustrating an example of a schematic configuration of an endoscopic surgical system to which the technology (the present technology) according to the present disclosure can be applied.

Fig. 41 illustrates a manner that a surgeon (physician) 11131 is performing surgery on a patient 11132 on a patient bed 11133 using an endoscopic surgical system 11000. As illustrated in the diagram, the endoscopic surgical system 11000 includes an endoscope 11100, surgical tools 11110 including a pneumoperitoneum tube 11111, an energy treatment tool 11112, and the like, a support arm device 11120 for supporting the endoscope 11100, and a cart 11200 on which various devices for endoscopic surgery are mounted.

The endoscope 11100 includes a lens barrel 11101 having a part of a predetermined length from its front end is inserted into a body cavity of the patient 11132, and a camera head 11102 connected to a base end of the lens barrel 11101. In the illustrated example, the endoscope 11100 configured as a so-called rigid mirror having a rigid lens barrel 11101 is illustrated, but the endoscope 11100 may be configured as a so-called flexible mirror having a flexible lens barrel.

At the front end of the lens barrel 11101, there is an opening having an objective lens fitted therein. To the endoscope 11100, a light source device 11203 is connected and the light generated by the light source device 11203 is guided to the front end of the lens barrel by a light guide extending inside the lens barrel 11101, and is emitted toward an observation target in a body cavity of the patient 11132 via the objective lens. Here, it should be noted that the endoscope 11100 may be a direct view mirror, a perspective mirror, or a side view mirror.

An optical system and an image pickup element are provided inside the camera head 11102, and reflected light (observation light) from the observation target is converged on the image pickup element by the optical system. The observation light is photoelectrically converted by the image pickup element, and an electric signal corresponding to the observation light, that is, an image signal corresponding to an observation image is generated. The image signal is transmitted as RAW data to a camera control unit (CCU) 11201.

The CCU 11201 is configured by a central processing unit (CPU), a graphics processing unit (GPU), and the like, and controls operation of the endoscope 11100 and a display device 11202 in an integrated manner. Furthermore, the CCU 11201 receives an image signal from the camera head 11102, and performs various image processing for displaying an image based on the image signal, such as development processing (demosaic processing) or the like, on the image signal.

The display device 11202 displays an image based on the image signal which is processed by the CCU 11201 under the control of the CCU 11201.

The light source device 11203 includes a light source such as a light emitting diode (LED), for example, and supplies irradiation light for photographing a surgery part or the like to the endoscope 11100.

The input device 11204 is an input interface to the endoscopic surgical system 11000. The user can input various kinds of information and an instruction to the endoscopic surgical system 11000 via the input device 11204. For example, the user inputs an instruction or the like to change a condition of imaging by the endoscope 11100 (type of irradiation light, magnification, focal length, and the like).

A treatment tool control device 11205 controls driving of the energy treatment tool 11112 for cauterizing tissue, cutting incisions, sealing blood vessels, or the like. The pneumoperitoneum device 11206 has a structure in which a gas is injected into the body cavity through the pneumoperitoneum tube 11111 so as to inflate the body cavity of the patient 11132 for the purpose of securing the visual field by the endoscope 11100 and securing the working space of the surgeon.

A recorder 11207 is a device capable of recording various kinds of information on surgery. A printer 11208 is a device capable of printing various kinds of information relating to surgery in various forms such as text, image, graph, and the like.

Here, it is to be noted that the light source device 11203 for supplying irradiation light for photographing a surgical area to the endoscope 11100 can be constituted by, for example, a white light source constituted by an LED, a laser light source, or a combination thereof. In a case where a white light source is configured by a combination of RGB laser light sources, since the output intensity and the output timing of each color (each wavelength) can be controlled with high precision, the white balance of the captured image can be adjusted by the light source device 11203. Furthermore, in this case, by irradiating the observation target with the laser light from each of the RGB laser light sources by time-sharing process and controlling the driving of the image pickup element of the camera head 11102 in synchronization with the irradiation timing, images corresponding to the respective RGB can be captured by time-sharing process. According to this method, a color image can be obtained without providing a color filter in the image pickup element.

Furthermore, the light source device 11203 may be controlled so as to change intensity of light to be output at predetermined time intervals. By controlling the driving of the image pickup element of the camera head 11102 in synchronization with the timing of the change of the light intensity, images are obtained in a time-sharing manner and those images are synthesized to generate an image, which is so-called high dynamic range image with no black crushed part or blown out highlights.

Furthermore, the light source device 11203 may be configured to be capable of supplying light of a predetermined wavelength band corresponding to special light observation. In the special light observation, for example, by using the wavelength dependency of the light absorption in a body tissue, so-called narrow band light observation (narrow band imaging) is performed, in which an image of a predetermined tissue such as a blood vessel of a mucosal surface layer is captured with high contrast by emitting light in a band, which is narrower than irradiation light (that is, white light) in a case of ordinary observation. Alternatively, in the special light observation, fluorescence observation for obtaining an image by using fluorescence generated by emitted excitation light may be performed. In fluorescence observation, it is possible to irradiate a body tissue with excitation light to observe fluorescence from the body tissue (auto-fluorescence observation), or to inject a reagent such as indocyanine green (ICG) into the body tissue and irradiate the body tissue with excitation light corresponding to a fluorescence wavelength of the reagent to obtain a fluorescent image and the like. The light source device 11203 can be made to supply narrow band light and/or excitation light corresponding to such special light observation.

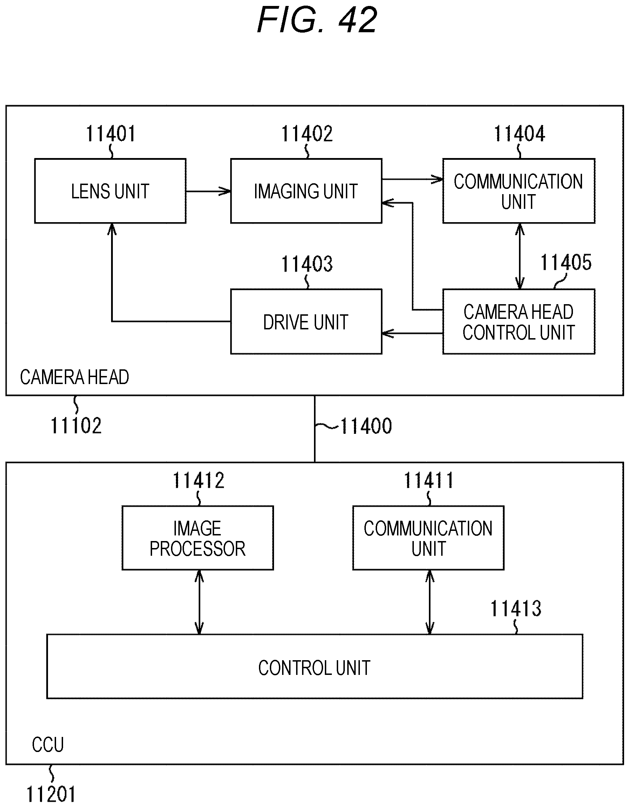

Fig. 42 is a block diagram illustrating an example of a functional configuration of the camera head 11102 and the CCU 11201 illustrated in Fig. 41.

The camera head 11102 includes a lens unit 11401, an imaging unit 11402, a drive unit 11403, a communication unit 11404, and a camera head control unit 11405. The CCU 11201 includes a communication unit 11411, an image processor 11412, and a control unit 11413. The camera head 11102 and the CCU 11201 are communicably connected to each other by a transmission cable 11400.

The lens unit 11401 is an optical system provided at a connection unit with the lens barrel 11101. The observation light taken in from the front end of the lens barrel 11101 is guided to the camera head 11102 and enters the lens unit 11401. The lens unit 11401 is formed by combining a plurality of lenses including a zoom lens and a focus lens.

The image pickup element constituting the imaging unit 11402 may be one (so-called single plate type) or a plurality of (so-called multi plate type) image pickup elements. In a case where the imaging unit 11402 includes a multi-plate type, image signals corresponding to R, G, and B may be generated, for example, by each image pickup element and may be combined to obtain a color image. Alternatively, the imaging unit 11402 may be configured to have a pair of image pickup elements for acquiring right-eye and left-eye image signals for three-dimensional (3D) displaying, respectively. With the 3D displaying, the surgeon 11131 can further accurately recognize a depth of the living tissue in the surgery area. Note that, in a case where the imaging unit 11402 includes a multi-plate type, a plurality of lens units 11401 can also be provided corresponding to each image pickup element.

In addition, the imaging unit 11402 is not necessarily provided in the camera head 11102. For example, the imaging unit 11402 may be provided inside the lens barrel 11101 immediately behind the objective lens.

The drive unit 11403 is constituted by an actuator and moves the zoom lens and the focus lens of the lens unit 11401 by a predetermined distance along the optical axis under the control of the camera head control unit 11405. As a result, magnification and focus of the image captured by the imaging unit 11402 can be appropriately adjusted.

The communication unit 11404 includes a communication device for transmitting and receiving various types of information to and from the CCU 11201. The communication unit 11404 transmits the image signal obtained from the imaging unit 11402 as RAW data to the CCU 11201 via the transmission cable 11400.

In addition, the communication unit 11404 receives a control signal for controlling driving of the camera head 11102 from the CCU 11201, and supplies the control signal to the camera head control unit 11405. The control signal includes, for example, information associated with imaging conditions such as information designating a frame rate of the captured image, information designating an exposure value at the time of image capturing, and/or information specifying magnification and focus of the captured image.

Note that the imaging conditions such as the above frame rate, exposure value, magnification, focus, and the like may be appropriately designated by a user or automatically set by the control unit 11413 of the CCU 11201 on the basis of the acquired image signal. In the latter case, so-called auto exposure (AE) function, auto focus (AF) function, and auto white balance (AWB) function are installed in the endoscope 11100.

The camera head control unit 11405 controls driving of the camera head 11102 on the basis of a control signal from the CCU 11201 received via the communication unit 11404.

The communication unit 11411 includes a communication device for transmitting and receiving various types of information to and from the camera head 11102. The communication unit 11411 receives an image signal transmitted from the camera head 11102 via the transmission cable 11400.

Furthermore, the communication unit 11411 transmits a control signal for controlling the driving of the camera head 11102 to the camera head 11102. The image signal and the control signal can be transmitted by electric communication, optical communication, or the like.

The image processor 11412 performs various types of image processing on the image signal which is RAW data transmitted from the camera head 11102.

The control unit 11413 performs various types of control related to imaging of a surgery area or the like by the endoscope 11100 and displaying of captured images obtained by imaging the surgery area or the like. For example, the control unit 11413 generates a control signal for controlling the driving of the camera head 11102.

In addition, the control unit 11413 causes the display device 11202 to display the captured image including the surgery area or the like on the basis of the image signal subjected to the image processing by the image processor 11412. In this case, the control unit 11413 may recognize various types of objects in the captured image using various types of image recognition techniques. For example, by detecting the shape, color, and the like of the edge of the object included in the captured image, the control unit 11413 can recognize a surgical tool such as a forceps, a specific body part, bleeding, a mist in a case of using the energy treatment tool 11112, and the like. In a case where the display device 11202 is caused to display a captured image, the control unit 11413 may superimpose various kinds of surgical operation support information on the image of the surgery area using the recognition result to display. In a case where the surgical operation support information is superimposed and presented to the surgeon 11131, this may reduce a burden on the surgeon 11131 and help the surgeon 11131 to reliably proceed the surgery.

The transmission cable 11400 that connects the camera head 11102 and the CCU 11201 is an electric signal cable compatible with electric signal communication, an optical fiber compatible with optical communication, or a composite cable thereof.

Here, in the illustrated example, communication is performed by wire using the transmission cable 11400; however communication between the camera head 11102 and the CCU 11201 may be performed wirelessly.

The above description has explained an example of an endoscopic surgical system to which the technology related to the present disclosure can be applied. The technology according to the present disclosure can be applied to, for example, the camera head 11102 and the imaging unit 11402 of the camera head 11102, in the above described configurations. More specifically, for example, the image pickup element 12 of Fig. 1 can be applied to the imaging unit 11402. By applying the technology according to the present disclosure to the imaging unit 11402, a surgery area image with a higher image quality can be obtained so that the surgeon can surely confirm the operation site.

Note that, although an endoscopic surgical system has been described as an example here, the technology according to the present disclosure may be applied to, for example, a microscopic surgery system or the like.

<Example of application to moving body>

Furthermore, for example, the technology related to the present disclosure can be realized as a device to be mounted in a moving body in any one of types including vehicles, electric vehicles, hybrid electric vehicles, motorcycles, bicycles, personal mobilities, airplanes, drones, vessels, robots, and the like.

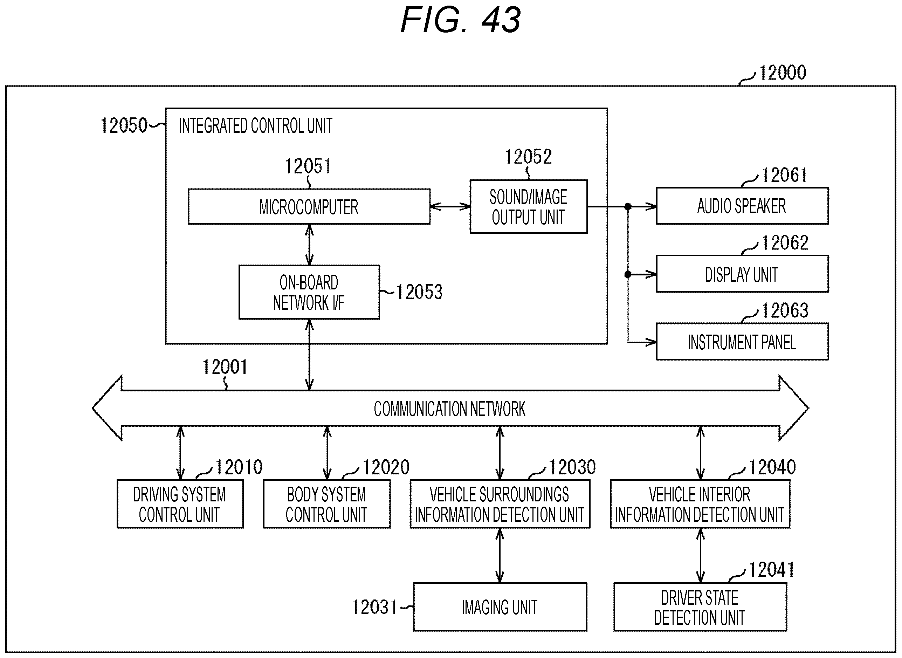

Fig. 43 is a block diagram illustrating a schematic configuration example of a vehicle control system as an example of a moving body control system to which the technology related to the present disclosure can be applied.

A vehicle control system 12000 includes a plurality of electronic control units connected via a communication network 12001. In the example illustrated in Fig. 43, the vehicle control system 12000 includes a driving system control unit 12010, a body system control unit 12020, a vehicle surroundings information detection unit 12030, a vehicle interior information detection unit 12040, and an integrated control unit 12050. Furthermore, as a functional configuration of the integrated control unit 12050, a microcomputer 12051, a sound/image output unit 12052, and an on-board network interface (I/F) 12053 are illustrated.

The driving system control unit 12010 controls operation of a device related to a vehicle driving system according to various programs. For example, the driving system control unit 12010 functions as a control device such as a driving force generation device for generating a driving force of a vehicle such as an engine or a drive motor, a driving force transmission mechanism for transmitting the driving force to a wheel, a steering mechanism for adjusting a vehicular steering angle, and a braking system for generating vehicular braking force.

The body system control unit 12020 controls operation of various devices mounted in the vehicle according to various programs. For example, the body system control unit 12020 functions as a control device of a keyless entry system, a smart key system, a power window device, or various lamps such as a head lamp, a back lamp, a brake lamp, a blinker, and a fog lamp. In this case, to the body system control unit 12020, radio waves or signals of various switches sent from a mobile device serving as a substitute of a key can be input. The body system control unit 12020 receives these inputs of radio wave or signals and controls a door lock device, a power window device, a lamp, or the like of the vehicle.

The vehicle surroundings information detection unit 12030 detects information from the outside of the vehicle in which the vehicle control system 12000 is mounted. For example, to the vehicle surroundings information detection unit 12030, the imaging unit 12031 is connected. The vehicle surroundings information detection unit 12030 causes the imaging unit 12031 to capture an image of the outside of the vehicle and receives the captured image. On the basis of the received image, the vehicle surroundings information detection unit 12030 may perform a process of detecting an object including a person, a vehicle, an obstacle, a sign, a letter on a street surface, or the like or a process of detecting a distance.

The imaging unit 12031 is an optical sensor that receives light and outputs an electrical signal corresponding to a light-receiving amount of the light. The imaging unit 12031 can output the electric signal as an image or output the electric signal as distance measurement information. Furthermore, the light the imaging unit 12031 receives may be visible light or invisible light such as infrared light.

The vehicle interior information detection unit 12040 detects information inside the vehicle. To the vehicle interior information detection unit 12040, for example, a driver state detection unit 12041 for detecting a state of a driver is connected. The driver state detection unit 12041 includes, for example, a camera for capturing an image of the driver, and the vehicle interior information detection unit 12040 may calculate a fatigue degree or a concentration degree of the driver on the basis of the detection information input from the driver state detection unit 12041 or may determine if the driver is surely awake.

The microcomputer 12051 can calculate a control target value of the driving force generation device, steering mechanism, or braking system on the basis of the vehicle interior and surroundings information obtained in the vehicle surroundings information detection unit 12030 or vehicle interior information detection unit 12040 and output a control command to the driving system control unit 12010. For example, the microcomputer 12051 can perform a coordinate control aiming to realize an advanced driver assistance system (ADAS) function including collision avoidance or impact relaxation of the vehicle, following travel based on an inter-vehicular distance, vehicle speed maintaining travel, vehicular collision-warning, vehicular lane departure warning, or the like.

Furthermore, the microcomputer 12051 can perform a coordinate control aiming at an automatic operation for autonomously traveling regardless of the driver's operation, or the like by controlling the driving force generation device, steering mechanism, braking system, or the like on the basis of vehicle surroundings information obtained by the vehicle surroundings information detection unit 12030 or vehicle interior information detection unit 12040.

Furthermore, the microcomputer 12051 can output a control command to the body system control unit 12020 on the basis of vehicle surroundings information obtained by the vehicle surroundings information detection unit 12030. For example, the microcomputer 12051 can control the head lamp according to a position of a preceding vehicle or an oncoming vehicle detected by the vehicle surroundings information detection unit 12030 and perform a coordinate control aiming to antidazzle by switching high beam to low beam, or the like.

The sound/image output unit 12052 transmits an output signal of at least one of a sound or an image to an output device which can visually or aurally notify a vehicular passenger or the outside of the vehicle of information. In the example of Fig. 43, as the output device, an audio speaker 12061, a display unit 12062, and an instrument panel 12063 are exemplified. The display unit 12062 may include, for example, at least one of an on-board display or a head-up display.

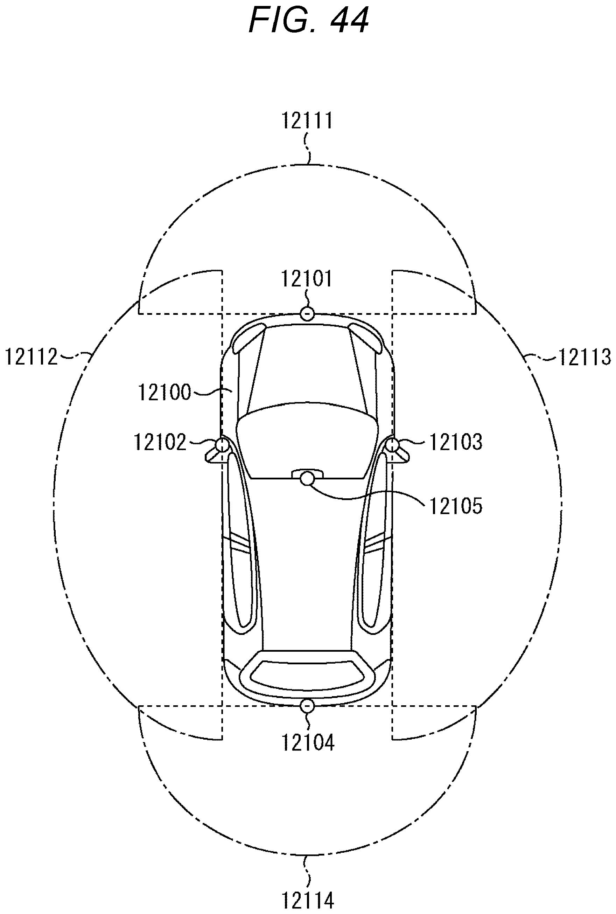

Fig. 44 is a diagram illustrating an example of a mounted position of the imaging unit 12031.

In Fig. 44, imaging units 12101, 12102, 12103, 12104, and 12105 are included as the imaging unit 12031.

The imaging units 12101, 12102, 12103, 12104, and 12105 are provided at positions on a front nose, side mirrors, a rear bumper, a back door, an upper portion of a windshield inside the vehicle, or the like of the vehicle 12100, for example. The imaging unit 12101 provided on the front nose and the imaging unit 12105 provided on the upper portion of the windshield inside the vehicle mainly obtain an image in front of the vehicle 12100. The imaging units 12102 and 12103 provided at the side mirrors mainly obtain images in sides of the vehicle 12100. The imaging unit 12104 provided at the rear bumper or back door mainly obtains an image behind the vehicle 12100. The imaging unit 12105 provided on the upper portion of the windshield inside the vehicle is mainly used for detecting a preceding vehicle, a pedestrian, an obstacle, a traffic signal, a traffic sign, a lane, and the like.

Note that Fig. 44 illustrates an example of coverages of the imaging units 12101 to 12104. A coverage 12111 represents the coverage of the imaging unit 12101 provided at the front nose, coverages 12112 and 12113 represents the coverages of the imaging units 12102 and 12103 respectively provided at the side mirrors, and a coverage 12114 represents the coverage of the imaging unit 12104 provided to the rear bumper or back door. For example, a high-angle image of the vehicle 12100 seen from the above can be obtained by overlaying the images taken by the imaging units 12101 to 12104.

At least one of the imaging units 12101 to 12104 may have a function for obtaining distance information. For example, at least one of the imaging units 12101 to 12104 may be a stereo camera including a plurality of image pickup elements or may be an image pickup element having a pixel for detecting a phase difference.

For example, the microcomputer 12051 can extract a three-dimensional object, which is especially existing closest to the vehicle 12100 on a roadway in a traveling direction and is traveling at a predetermined speed (for example, equal to or greater than 0 km/h) in an almost same direction with the vehicle 12100 as a preceding vehicle by obtaining distances to each three-dimensional object within the coverages 12111 to 12114 and temporal variation of the distances (relative velocity with respect to the vehicle 12100) on the basis of the distance information obtained from the imaging units 12101 to 12104. Furthermore, the microcomputer 12051 sets an inter-vehicular distance, which is to be maintained, before the preceding vehicle in advance, and can perform an automatic brake control (also including a follow-up stoppage control), an automatic acceleration control (also including a follow-up start control), and the like. A coordinate control aiming at an automatic operation for autonomously traveling regardless of the driver's operation in this manner, or the like can be performed.

For example, the microcomputer 12051 extracts three-dimensional object data related to the three-dimensional object as classifying into other three-dimensional objects such as motorcycles, typical vehicles, large-sized vehicle vehicles, pedestrians, and utility poles on the basis of the distance information obtained from the imaging units 12101 to 12104, and the extracted three-dimensional object data can be used in an obstacle automatic avoidance. For example, the microcomputer 12051 identifies obstacles around the vehicle 12100 into obstacles visible by the driver of the vehicle 12100 and obstacles hardly visible by the driver. Then, the microcomputer 12051 determines a collision risk indicating a risk of colliding with each obstacle and, in a condition that the collision risk is equal to or greater than a set value and there is a possibility of a collision, a drive assist for a collision avoidance by outputting a warning to the driver via the audio speaker 12061 or display unit 12062 or performing forced deceleration or avoidance steering via the driving system control unit 12010.

At least one of the imaging units 12101 to 12104 may be an infrared camera, which detects infrared ray. For example, the microcomputer 12051 can recognize pedestrians by determining whether or not there is a pedestrian in captured images of the imaging units 12101 to 12104. This pedestrian recognition is performed, for example, by a procedure for extracting a characteristic point in the captured images of the imaging units 12101 to 12104, which are infrared cameras or a procedure for determining whether or not the obstacle is a pedestrian by performing a pattern matching process on a series of characteristic points, which indicates an outline of the obstacle. In a case where the microcomputer 12051 determines that there is a pedestrian in the captured images of the imaging units 12101 to 12104 and recognizes the pedestrian, and the sound/image output unit 12052 controls the display unit 12062 to superimposedly display a rectangular outline that emphasizes the recognized pedestrian. Furthermore, the sound/image output unit 12052 may control the display unit 12062 to display an icon or the like indicating the pedestrian in a desired position.

In the above, an example of a vehicle control system to which the technology related to the present disclosure can be applied has been explained. The technology related to the present disclosure can be applied to, for example, the imaging unit 12031 in the above described configuration. More specifically, for example, the image pickup apparatus 10 of Fig. 1 can be applied to the imaging unit 12031. By applying the technique according to the present disclosure to the imaging unit 12031, for example, an image of the outside of the vehicle can be obtained with higher image quality, and an improvement in safety of automatic driving and the like can be achieved

10 Image pickup apparatus

11 Optical system

12, 12A to 12C Image pickup element

14 Signal processor

31, 31A to 311 Pixel array

51 Pixel

61 Photodiode

101 On-chip microlens

102 Interlayer film

103 Narrow band filter layer

104

Interlayer film 105 Photoelectric conversion element layer

106 Signal wiring layer

107 Color filter layer

108 Filter layer

121A to 121D Plasmon filter

131A to 131C Conductor thin film

132A to 132C' Hole

133A, 133B Dot

134A, 134B Dielectric layer

151 Plasmon filter

161A Moving body thin film

162 SiO2 film

163 SiN film

164 SiO2 substrate

203, 221 Semiconductor chip

301 Lens

312 Filter layer

314 Photoelectric conversion element layer

NB Narrow band filter

P Transmission filter

A1 to A4 Area

Lv Vertical line

Lh Horizontal

**Claims**

1. An image pickup element (12B, 12C) comprising:

a pixel array (31C to 31G) in which at least a first light receiving unit configured to receive light in a predetermined color and a second light receiving unit (MS) configured to receive light having a wavelength band having a band width narrower than a band width of a wavelength band of the predetermined color are arranged, wherein, in a case where the pixel array (31C-G) is divided into four areas (A1 to A4) by a vertical line (Lv) and a horizontal line (Lh), a position of the second light receiving unit in a first block, in which one or more of each of the first light receiving unit and the second light receiving unit are arranged, differs in each of the areas (A1 to A4),

wherein:

a second block including a fifth light receiving unit that receives red light, a third block including a sixth light receiving unit that receives green light, a fourth block including a seventh light receiving unit that receives green light, and a fifth block including an eighth light receiving unit that receives blue light are arranged in the pixel array (31C to 31G),

the first light receiving unit is one of the fifth light receiving unit to the eighth light receiving unit,

the first block is one of the second block to the fifth block,

in the second block to the fifth block, the light receiving units are arranged in two rows and two columns,

**characterized in that**

the colors of the second block to the fifth block in the pixel array are arranged such that the second to the fifth blocks form an arrangement of colors of Bayer array.

2. The image pickup element (12B, 12C) according to claim 1, wherein the position of the second light receiving unit in the first block in each of the areas (A1 to A4) is symmetrical with respect to an intersection of the vertical line (Lv) and the horizontal line (Lh).

3. The image pickup element (12B, 12C) according to claim 1, wherein the position of the second light receiving unit in the first block in each of the areas is symmetrical with respect to the vertical line (Lv) or the horizontal line (Lh).

4. The image pickup element (12B, 12C) according to claim 1, wherein a combination of colors received by a third light receiving unit which is closer to an intersection of the vertical line (Lv) and the horizontal line (Lh) among upper and lower light receiving units adjacent to the second light receiving unit, and received by a fourth light receiving unit which is closer to the intersection among right and left light receiving units adjacent to the second light receiving unit, correspond to each other between each of the second light receiving units.

5. The image pickup element (12B, 12C) according to claim 1, wherein the position of the second light receiving unit in the first block is set on a basis of sensitivity of the first light receiving unit in the first block such that the position of the second light receiving unit in the first block differs in each of the areas (A1 to A4), wherein an intersection of the vertical line (Lv) and the horizontal line (Lh) corresponds to a center of the pixel array, and, wherein an intersection of the vertical line (Lv) and the horizontal line (Lh) is on an optical axis of an optical system that leads light to the pixel array (31C to 31G).

6. The image pickup element (12B, 12C) according to claim 1, wherein the first light receiving unit and the second light receiving unit are pixels (51), respectively.

7. The image pickup element (12B, 12C) according to claim 1, wherein the first light receiving unit and the second light receiving unit are light receiving areas of a pixel (51), respectively.

8. The image pickup element (12B, 12C) according to claim 1, wherein a second optical filter used in the second light receiving unit is an optical filter that has a transmission band having a band width narrower than a band width of a first optical filter used in the first light receiving unit.

9. The image pickup element (12B, 12C) according to claim 8, wherein the second optical filter is a plasmon filter, or wherein the second optical filter is a Fabry-Perot interference filter.

10. An electronic device comprising:

an image pickup element (12B, 12C) according to claim 1; and
a signal processor (14) configured to process a signal output from the image pickup element.

**Patentansprüche**

1. Bildaufnahmeelement (12B, 12C), umfassend:

   ein Pixelarray (31C bis 31G), in dem mindestens eine erste Lichtempfangseinheit, die konfiguriert ist, um Licht in einer vorbestimmten Farbe zu empfangen, und eine zweite Lichtempfangseinheit (MS), die konfiguriert ist, um Licht zu empfangen, das ein Wellenlängenband aufweist, das eine Bandbreite aufweist, die schmaler ist als eine Bandbreite eines Wellenlängenbands der vorbestimmten Farbe, eingerichtet sind,
   wobei in einem Fall, in dem das Pixelarray (31C-G) durch eine vertikale Linie (Lv) und eine horizontale Linie (Lh) in vier Bereiche (A1 bis A4) unterteilt ist, eine Position der zweiten Lichtempfangseinheit in einem ersten Block, in dem eine oder mehrere jeder der ersten Lichtempfangseinheit und der zweiten Lichtempfangseinheit eingerichtet sind, in jedem der Bereiche (A1 bis A4) unterschiedlich ist,
   wobei:

   ein zweiter Block, der eine fünfte Lichtempfangseinheit einschließt, die rotes Licht empfängt, ein dritter Block, der eine sechste Lichtempfangseinheit einschließt, die grünes Licht empfängt, ein vierter Block, der eine siebte Lichtempfangseinheit einschließt, die grünes Licht empfängt, und ein fünfter Block, der eine achte Lichtempfangseinheit einschließt, die blaues Licht empfängt, in dem Pixelarray (31C bis 31G) eingerichtet sind,
   die erste Lichtempfangseinheit eine der fünften Lichtempfangseinheit zu der achten Lichtempfangseinheit ist,
   der erste Block einer des zweiten Blocks zu dem fünften Block ist,
   in dem zweiten zu dem fünften Block die Lichtempfangseinheiten in zwei Reihen und zwei Spalten eingerichtet sind,
   **dadurch gekennzeichnet, dass**
   die Farben des zweiten zu dem fünften Block in dem Pixelarray derart eingerichtet sind, dass der zweite zu dem fünften Block eine Farbeinrichtung eines Bayerarrays bilden.

2. Bildaufnahmeelement (12B, 12C) nach Anspruch 1, wobei die Position der zweiten Lichtempfangseinheit in dem ersten Block in jedem der Bereiche (A1 bis A4) in Bezug auf einen Schnittpunkt der vertikalen Linie (Lv) und der horizontalen Linie (Lh) symmetrisch ist.

3. Bildaufnahmeelement (12B, 12C) nach Anspruch 1, wobei die Position der zweiten Lichtempfangseinheit in dem ersten Block in jedem der Bereiche in Bezug auf die vertikale Linie (Lv) oder die horizontale Linie (Lh) symmetrisch ist.

4. Bildaufnahmeelement (12B, 12C) nach Anspruch 1, wobei eine Kombination von Farben, die durch eine dritte Lichtempfangseinheit empfangen werden, die näher an einem Schnittpunkt der vertikalen Linie (Lv) und der horizontalen Linie (Lh) unter oberen und unteren Lichtempfangseinheiten angrenzend an der zweiten Lichtempfangseinheit liegt, und die durch eine vierte Lichtempfangseinheit empfangen werden, die näher an dem Schnittpunkt zwischen rechten und linken Lichtempfangseinheiten angrenzend an der zweiten Lichtempfangseinheit liegt, zwischen jeder der zweiten Lichtempfangseinheiten einander entsprechen.

5. Bildaufnahmeelement (12B, 12C) nach Anspruch 1, wobei die Position der zweiten Lichtempfangseinheit in dem ersten Block auf einer Basis einer Empfindlichkeit der ersten Lichtempfangseinheit in dem ersten Block derart eingestellt ist, dass die Position der zweiten Lichtempfangseinheit in dem ersten Block in jedem der Bereiche (A1 bis A4) unterschiedlich ist, wobei ein Schnittpunkt der vertikalen Linie (Lv) und der horizontalen Linie (Lh) einem Mittelpunkt des Pixelarrays entspricht, und wobei ein Schnittpunkt der vertikalen Linie (Lv) und der horizontalen Linie (Lh) auf einer optischen Achse eines optischen Systems liegt, das Licht zu dem Pixelarray (31C bis 31G) leitet.

6. Bildaufnahmeelement (12B, 12C) nach Anspruch 1, wobei die erste Lichtempfangseinheit und die zweite Lichtempfangseinheit jeweils Pixel (51) sind.

7. Bildaufnahmeelement (12B, 12C) nach Anspruch 1, wobei die erste Lichtempfangseinheit und die zweite Lichtempfangseinheit jeweils Lichtempfangsbereiche eines Pixels (51) sind.

8. Bildaufnahmeelement (12B, 12C) nach Anspruch 1, wobei ein zweiter optischen Filter, der in der zweiten Lichtempfangseinheit verwendet wird, ein optischer Filter ist, der ein Übertragungsband aufweist, das eine Bandbreite aufweist, die schmaler ist als eine Bandbreite eines ersten optischen Filters, der in der ersten Lichtempfangseinheit verwendet wird.

**9.** Bildaufnahmeelement (12B, 12C) nach Anspruch 8, wobei der zweite optische Filter ein Plasmonenfilter ist oder wobei der zweite optische Filter ein Fabry-Perot-Interferenzfilter ist.

**10.** Elektronische Vorrichtung, umfassend:

ein Bildaufnahmeelement (12B, 12C) nach Anspruch 1; und
einen Signalprozessor (14), der konfiguriert ist, um ein Signal, das aus dem Bildaufnahmeelement ausgegeben wird, zu verarbeiten.

**Revendications**

**1.** Élément de capture d'image (12B, 12C) comprenant :

une matrice de pixels (31C à 31G) dans laquelle au moins une première unité de réception de lumière configurée pour recevoir de la lumière dans une couleur prédéterminée et une deuxième unité de réception de lumière (MS) configurée pour recevoir de la lumière ayant une bande de longueur d'onde ayant une largeur de bande plus étroite qu'une largeur de bande d'une bande de longueur d'onde de la couleur prédéterminée sont agencées, dans lequel, dans un cas où la matrice de pixels (31C-G) est divisée en quatre zones (A1 à A4) par une barre verticale (Lv) et une ligne horizontale (Lh), une position de la deuxième unité de réception de lumière dans un premier bloc, dans lequel une ou plusieurs parmi chacune parmi la première unité de réception de lumière et la deuxième unité de réception de lumière sont agencées, diffère dans chacune des zones (A1 à A4), dans lequel :

un deuxième bloc comportant une cinquième unité de réception de lumière qui reçoit de la lumière rouge, un troisième bloc comportant une sixième unité de réception de lumière qui reçoit de la lumière verte, un quatrième bloc comportant une septième unité de réception de lumière qui reçoit de la lumière verte, et un cinquième bloc comportant une huitième unité de réception de lumière qui reçoit de la lumière bleue sont agencés dans la matrice de pixels (31C à 31G),
la première unité de réception de lumière est l'une parmi la cinquième unité de réception de lumière à la huitième unité de réception de lumière,
le premier bloc est l'un parmi le deuxième bloc au cinquième bloc,
dans le deuxième bloc au cinquième bloc, les unités de réception de lumière sont agencées en deux rangées et deux colonnes,
**caractérisé en ce que**
les couleurs du deuxième bloc au cinquième bloc dans la matrice de pixels sont agencées de telle sorte que les deuxième au cinquième blocs forment un agencement de couleurs de matrice de Bayer.

**2.** Élément de capture d'image (12B, 12C) selon la revendication 1, dans lequel la position de la deuxième unité de réception de lumière dans le premier bloc dans chacune des zones (A1 à A4) est symétrique par rapport à une intersection de la barre verticale (Lv) et de la ligne horizontale (Lh).

**3.** Élément de capture d'image (12B, 12C) selon la revendication 1, dans lequel la position de la deuxième unité de réception de lumière dans le premier bloc dans chacune des zones est symétrique par rapport à la barre verticale (Lv) ou à la ligne horizontale (Lh).

**4.** Élément de capture d'image (12B, 12C) selon la revendication 1, dans lequel une combinaison de couleurs reçue par une troisième unité de réception de lumière qui est plus près d'une intersection de la barre verticale (Lv) et de la ligne horizontale (Lh) parmi les unités de réception de lumière supérieure et inférieure adjacentes à la deuxième unité de réception de lumière, et reçue par une quatrième unité de réception de lumière qui est plus près de l'intersection parmi les unités de réception de lumière droite et gauche adjacentes à la deuxième unité de réception de lumière, correspondent l'une à l'autre entre chacune des deuxièmes unités de réception de lumière.

**5.** Élément de capture d'image (12B, 12C) selon la revendication 1, dans lequel la position de la deuxième unité de réception de lumière dans le premier bloc est réglée en fonction de la sensibilité de la première unité de réception de lumière dans le premier bloc de telle sorte que la position de la deuxième unité de réception de lumière dans le premier bloc diffère dans chacune des zones (A1 à A4), dans lequel une intersection de la barre verticale (Lv) et de la ligne horizontale (Lh) correspond à un centre de la matrice de pixels et, dans lequel une intersection de la barre verticale (Lv) et de la ligne horizontale (Lh) est sur un axe optique d'un système optique qui conduit la lumière vers la matrice de pixels (31C à 31G).

6. Élément de capture d'image (12B, 12C) selon la revendication 1, dans lequel la première unité de réception de lumière et la deuxième unité de réception de lumière sont des pixels (51), respectivement.

7. Élément de capture d'image (12B, 12C) selon la revendication 1, dans lequel la première unité de réception de lumière et la deuxième unité de réception de lumière sont des zones de réception de lumière d'un pixel (51), respectivement.

8. Élément de capture d'image (12B, 12C) selon la revendication 1, dans lequel un second filtre optique utilisé dans la deuxième unité de réception de lumière est un filtre optique qui a une bande de transmission ayant une largeur de bande plus étroite qu'une largeur de bande d'un premier filtre optique utilisé dans la première unité de réception de lumière.

9. Élément de capture d'image (12B, 12C) selon la revendication 8, dans lequel le second filtre optique est un filtre plasmonique, ou dans lequel le second filtre optique est un filtre d'interférence de Fabry-Perot.

10. Dispositif électronique comprenant :

un élément de capture d'image (12B, 12C) selon la revendication 1 ; et
un processeur de signal (14) configuré pour traiter un signal délivré en sortie par l'élément de capture d'image.

## FIG. 1

*FIG. 2*

ROW SCANNING CIRCUIT

COLUMN SCANNING CIRCUIT

SENSE AMPLIFIER

DAC

PLL

COUNTER

12 31 51 32 33 34 35 36 37 71 72 61 62 63 64 65 66

V H

FIG. 3

## FIG. 4

## FIG. 5

FIG. 6

## FIG. 7

# FIG. 8

EP 3 557 625 B1

# FIG. 9

EP 3 557 625 B1

# FIG. 10

# FIG. 11

# FIG. 12

FIG. 13

## FIG. 14

## FIG. 15

FIG. 16

# FIG. 17

EP 3 557 625 B1

FIG. 18

EP 3 557 625 B1

# FIG. 19

FIG. 20

EP 3 557 625 B1

FIG. 21

EP 3 557 625 B1

# FIG. 22

# FIG. 23

# FIG. 24

# FIG. 25

LIGHT

| Gr.1 | Gr.2 | R1 | R2 |
| Gr.3 | Gr.4 | R3 | R4 |
| B1 | B2 | Gb1 | Gb2 |
| B3 | B4 | Gb3 | Gb4 |

R3        Gb1

~311
~312
~313

~314

COLOR MIXING IS LESS LIKELY TO OCCUR
IN CASE WHERE ADJACENT PIXELS ARE
IN DIFFERENT COLORS.

Gb2        Gb4

~311
~312
~313

~314

COLOR MIXING IS LIKELY TO OCCUR
IN CASE WHERE ADJACENT PIXELS ARE
IN SAME COLOR.

# FIG. 26

# FIG. 27

# FIG. 28

# FIG. 29

## FIG. 30

# FIG. 31

# FIG. 32

# FIG. 33

# FIG. 34

# FIG. 35

EP 3 557 625 B1

# FIG. 36

# FIG. 37

SECURITY

BEAUTY CARE

MEDICAL,
HEALTH CARE

SPORTS

IMAGE SENSOR

HOME ELECTRIC
APPLIANCES

FARMING

TRAFFIC

ENTERTAINMENT

EP 3 557 625 B1

# FIG. 38

| DETECTION TARGET | DETECTION ITEM | PEAK WAVELENGTH | HALF VALUE WIDTH |
|---|---|---|---|
| MYOGLOBIN | FLAVOR COMPONENT | 580–630nm | 30–50nm |
| OLEIC ACID | FRESHNESS | 970nm | 50–100nm |
| CHLOROPHYLL | FRESHNESS | 650–700nm | 50–100nm |

EP 3 557 625 B1

# FIG. 39

| FRUIT | DETECTION TARGET | DETECTION ITEM | PEAK WAVELENGTH | HALF VALUE WIDTH |
|---|---|---|---|---|
| MELON RAIDEN | SUGAR CONTENT | FRUIT PULP OPTICAL PATH LENGTH | 880nm | 20-30nm |
| | | SUCROSE | 910nm | 40-50nm |
| MELON RAIDEN RED | SUGAR CONTENT | SUCROSE | 915nm | 40-50nm |
| | | MOISTURE CONTENT | 955nm | 20-30nm |
| APPLE | SUGAR CONTENT | SUCROSE | 912nm | 40-50nm |
| ORANGE | MOISTURE CONTENT | MOISTURE | 844nm | 30nm |
| | SUGAR CONTENT | SUCROSE | 914nm | 40-50nm |

EP 3 557 625 B1

# FIG. 40

| DETECTION TARGET | PEAK WAVELENGTH | HALF VALUE WIDTH |
|:---:|:---:|:---:|
| PET | 1669nm | 30–50nm |
| PS | 1688nm | 30–50nm |
| PE | 1735nm | 30–50nm |
| PVC | 1716～1726nm | 30–50nm |
| PP | 1716～1735nm | 30–50nm |

# FIG. 41

EP 3 557 625 B1

# FIG. 42

**CAMERA HEAD**

11401
LENS UNIT

11402
IMAGING UNIT

11404
COMMUNICATION UNIT

11403
DRIVE UNIT

11405
CAMERA HEAD CONTROL UNIT

CAMERA HEAD

11102

~11400

**CCU**

11412
IMAGE PROCESSOR

11411
COMMUNICATION UNIT

11413

CONTROL UNIT

CCU

11201

## FIG. 43

12000

12050 — INTEGRATED CONTROL UNIT

12051
MICROCOMPUTER

12052
SOUND/IMAGE OUTPUT UNIT

12053
ON-BOARD NETWORK I/F

12061
AUDIO SPEAKER

12062
DISPLAY UNIT

12063
INSTRUMENT PANEL

12001
COMMUNICATION NETWORK

12010
DRIVING SYSTEM CONTROL UNIT

12020
BODY SYSTEM CONTROL UNIT

12030
VEHICLE SURROUNDINGS INFORMATION DETECTION UNIT

12040
VEHICLE INTERIOR INFORMATION DETECTION UNIT

12031
IMAGING UNIT

12041
DRIVER STATE DETECTION UNIT

EP 3 557 625 B1

# FIG. 44

**EP 3 557 625 B1**

**REFERENCES CITED IN THE DESCRIPTION**

**Patent documents cited in the description**

- WO 2016059369 A
- US 2014009647 A1
- US 2008170143 A1
- US 2014084404 A1